(19) Europäisches Patentamt
European Patent Office
Office européen des brevets

(11) **EP 2 351 461 B1**

(12) **EUROPÄISCHE PATENTSCHRIFT**

(45) Veröffentlichungstag und Bekanntmachung des Hinweises auf die Patenterteilung:
**12.06.2013   Patentblatt 2013/24**

(21) Anmeldenummer: **09799503.9**

(22) Anmeldetag: **13.11.2009**

(51) Int Cl.:
***H05B 33/08*** *(2006.01)*

(86) Internationale Anmeldenummer:
**PCT/DE2009/001626**

(87) Internationale Veröffentlichungsnummer:
**WO 2010/054650 (20.05.2010 Gazette 2010/20)**

(54) **OPTOELEKTRONISCHE VORRICHTUNG**

OPTOELECTRONIC DEVICE

APPAREIL OPTOELECTRONIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **14.11.2008   DE 102008057347**

(43) Veröffentlichungstag der Anmeldung:
**03.08.2011   Patentblatt 2011/31**

(73) Patentinhaber: **OSRAM Opto Semiconductors GmbH**
**93055 Regensburg (DE)**

(72) Erfinder: **WIRTH, Ralph**
**93098 Mintraching - Auhof (DE)**

(74) Vertreter: **Epping - Hermann - Fischer Patentanwaltsgesellschaft mbH**
**Ridlerstrasse 55**
**80339 München (DE)**

(56) Entgegenhaltungen:
**EP-A2- 1 950 490      WO-A1-2007/060570**
**DE-A1- 19 933 735      JP-A- 5 109 504**
**JP-A- 2002 008 904      US-A1- 2005 185 113**
**US-A1- 2007 171 159      US-A1- 2008 111 505**

• **"Data Sheet: Circuit Protection Thermistors NT05 25311" 12. August 2002 (2002-08-12), Amatherm Inc. , Carson City, NV, USA , XP002574194 das ganze Dokument**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Diese Patentanmeldung beansprucht die Prioritäten der deutschen Patentanmeldung 10 2008 057 347.7.

Es wird eine optoelektronische Vorrichtung zur Abstrahlung eines Mischlichts angegeben.

Zur Erzeugung von Mischlicht, also nicht-monochromatischem Licht und hierbei beispielsweise weißem Licht, werden unter Verwendung von lichtemittierenden Dioden (LEDs) üblicherweise verschiedenfarbig emittierende LEDs und/oder mehrere Leuchtstoffe eingesetzt. Um beispielsweise weißes Licht zu erzeugen, können spektrale Komponenten im gelb-grünen und im roten Wellenlängenbereich überlagert werden, die von verschiedenen LEDs abgestrahlt werden. Herausfordernd ist hier allerdings neben der Erfüllung optischer Vorgaben wie etwa der Mischung von Licht, das von verschiedenen LED-Chips emittiert wird, auch die Stabilisierung des Farborts, etwa bei weißem Licht des Weißpunkts, gegenüber der Temperatur. Dies liegt beispielsweise an verschiedenen Temperaturabhängigkeiten der beteiligten Chip-Technologien. Eine Steuerung auf einen einzigen Farbort ist üblicherweise nur unter Verwendung von zumindest drei verschiedenen LEDs möglich, etwa zur Erzeugung von weißem Mischlicht durch eine gelb-grün, eine rot und zusätzlich ein blau emittierende LED.

Die Druckschrift US 2007/171159 A1 beschreibt eine Treiberschaltung für eine Farb-LED mit parallel miteinander verschalteten rot, grün und blau emittieren LED-Einheiten, wobei die rot und die grün emittierende LED-Einheit jeweils in Serie mit einer ersten und einer zweiten Temperaturkompensationsschaltung verschaltet sind, die jeweils neben Festwiderständen parallel zu diesen verschaltete NTC-Thermistoren aufweisen. Die erste und zweite Temperaturkompensationsschaltung gleichen temperaturbedingte Helligkeitsschwankungen der rot und grün emittierenden LED-Einheiten aus, während die blau emittierende LED-Einheit kaum eine temperaturabhängige Abstrahlintensität aufweist.

Die Druckschrift US 2008/111505 A1 offenbart eine LED-Vorrichtung mit einer roten, einer grünen und einer blauen LED, die mit Temperatur kontrollierenden und Strom regulierenden Elementen in Form von PTC-Elementen in Serie verschaltet sind und mit diesen drei Zweige einer Parallelschaltung bilden.

Die Druckschriften JP 2002-008904 A und "Data Sheet: Circuit Protection Thermistors NT05 25311", 12. August 2002, Amatherm Inc., Carson City, NV, USA, XP-002574194 beschreiben PTC- und NTC-Elemente.

Die Druckschrift EP 1 950 490 A2 beschreibt eine Lichtquelle mit einer Serienschaltung aus drei Parallelschaltungen, die jeweils eine einzelne oder eine Mehrzahl von einfarbigen LEDs sowie parallel dazu Widerstandsschaltungen mit Widerständen sowie jeweils einem NTC-Element aufweisen.

In den Druckschriften US 2005/185113 A1 und WO 2007/060570 A1 sind Licht emittierende Dioden beschrieben, die einen Leuchtstoff zur Erzeugung von mischfarbigem Licht, beispielsweise weißem Licht, aufweisen.

Zumindest eine Aufgabe von bestimmten Ausführungsformen ist es, eine optoelektronische Vorrichtung zur Abstrahlung von Licht mit einer ersten und einer zweiten Halbleiterlichtquelle anzugeben.

Diese Aufgabe wird durch einen Gegenstand mit den Merkmalen des unabhängigen Patentanspruchs gelöst. Vorteilhafte Ausführungsformen und Weiterbildungen des Gegenstands sind in den abhängigen Ansprüchen gekennzeichnet und gehen weiterhin aus der nachfolgenden Beschreibung und den Zeichnungen hervor.

Eine optoelektronische Vorrichtung gemäß zumindest einer Ausführungsform zur Abstrahlung von Mischlicht mit Licht in einem ersten und einem zweiten Wellenlängenbereich umfasst insbesondere

- eine erste Halbleiterlichtquelle mit einer ersten lichtemittierenden Diode (LED), die im Betrieb Licht im ersten Wellenlängenbereich mit einer ersten Intensität abstrahlt,
- eine zweite Halbleiterlichtquelle mit einer zweiten LED, die im Betrieb Licht im zweiten Wellenlängenbereich mit einer zweiten Intensität abstrahlt, wobei der erste und zweite Wellenlängenbereich voneinander verschieden sind, und
- ein Widerstandselement mit einem temperaturabhängigen elektrischen Widerstand,

wobei

- der erste Wellenlängenbereich und/oder die erste Intensität des von der ersten Halbleiterlichtquelle abgestrahlten Lichts eine erste Temperaturabhängigkeit aufweist und
- der zweite Wellenlängenbereich und/oder die zweite Intensität des von der zweiten Halbleiterlichtquelle abgestrahlten Lichts eine zweite Temperaturabhängigkeit aufweist, die verschieden von der ersten Temperaturabhängigkeit ist,
- das Widerstandselement und die erste Halbleiterlichtquelle eine Serienschaltung bilden und
- die Serienschaltung und die zweite Halbleiterlichtquelle eine Parallelschaltung bilden.

Hier und im Folgenden kann "Licht" insbesondere elektromagnetische Strahlung mit einer oder mehreren Wellenlängen oder Wellenlängenbereichen aus einem ultravioletten bis infraroten Spektralbereich bezeichnen. Insbesondere kann Licht sichtbares Licht sein und Wellenlängen oder Wellenlängenbereiche aus einem sichtbaren Spektralbereich zwischen etwa 350 nm und etwa 800 nm umfassen. Sichtbares Licht kann hier und im Folgenden beispielsweise durch seinen Farbort mit x- und y-Farbortkoordinaten gemäß der einem Fachmann bekannten so genannten CIE-1931-Farborttafel beziehungsweise CIE-Normfarbtafel charakterisierbar sein.

Als weißes Licht oder Licht mit einem weißen Leucht- oder Farbeindruck kann hier und im Folgenden Licht mit einem Farbort bezeichnet werden, der dem Farbort eines planckschen Schwarzkörperstrahlers entspricht oder um weniger als 0,1 und bevorzugt um weniger als 0,05 in x- und/oder y-Farbortkoordinaten vom Farbort eines plankschen Schwarzkörperstrahlers abweicht. Weiterhin kann ein hier und im Folgenden als weißer Leuchteindruck bezeichneter Leuchteindruck durch Licht hervorgerufen werden, das einen einem Fachmann bekannten Farbwiedergabeindex ("color rendering index", CRI) von größer oder gleich 60, bevorzugt von größer oder gleich 70 und besonders bevorzugt von größer oder gleich 80 aufweist.

Weiterhin kann als "warmweiß" hier und im Folgenden ein Leuchteindruck bezeichnet sein, der eine Farbtemperatur von kleiner oder gleich 5500 K aufweist. Als "kaltweiß" kann hier und im Folgenden ein weißer Leuchteindruck bezeichnet sein, der eine Farbtemperatur von größer als 5500 K aufweist. Der Begriff "Farbtemperatur" kann hier und im Folgenden die Farbtemperatur eines planckschen Schwarzkörperstrahlers bezeichnen oder auch die dem Fachmann bekannte so genannte korrelierte Farbtemperatur ("correlated color temperature", CCT) im Falle eines weißen Leuchteindrucks im oben beschriebenen Sinne, der durch Farbortkoordinaten charakterisiert werden kann, die von den Farbortkoordinaten der planckschen Schwarzkörperstrahler abweichen.

Ein erster und ein zweiter Leuchteindruck können hier und im Folgenden als "verschieden" bezeichnet werden, wenn der erste Leuchteindruck durch Licht mit einem ersten Farbort und der zweite Leuchteindruck von Licht mit einem zweiten Farbort hervorgerufen wird und der erste Farbort als verschieden vom zweiten Farbort wahrnehmbar ist. Verschiedene Leuchteindrücke können insbesondere durch voneinander verschiedene erste und zweite Wellenlängenbereiche hervorgerufen werden. Hier und im Folgenden können ein erster und ein zweiter Wellenlängenbereich dementsprechend als verschieden bezeichnet sein, wenn etwa der erste Wellenlängenbereich zumindest eine spektrale Komponente aufweist, die nicht im zweiten Wellenlängenbereich enthalten ist. Dabei sei betont, dass ein erster und zweiter Wellenlängenbereich, die verschieden voneinander sind, durchaus auch gleiche spektrale Komponenten aufweisen können, solange wenigstens einer der beiden Wellenlängenbereiche eine spektrale Komponente aufweist, die nicht oder nicht mit derselben relativen Intensität im anderen Wellenlängenbereich enthalten ist, so dass der erste und zweite Wellenlängenbereiche jeweilige Leucht- und Farbeindrücke mit unterschiedlicher x- und/oder unterschiedlicher y-Koordinate in der CIE-Normfarbtafel hervorrufen.

Hier und im Folgenden werden ein erster und zweiter Farbort oder Leuchteindruck als voneinander verschieden wahrnehmbar bezeichnet, wenn diese von einem durchschnittlichen menschlichen Betrachter als verschieden voneinander wahrnehmbar sind. Insbesondere sind ein erster und zweiter Leuchteindruck mit einem ersten und zweiten Farbort nicht verschieden im Sinne der vorliegenden Anmeldung, wenn der erste und zweite Farbort in derselben MacAdams-Ellipse liegen. Das Konzept der MacAdams-Ellipsen in Bezug auf Wahrnehmbarkeiten von Farbunterschieden ist dem Fachmann bekannt und wird hier nicht weiter ausgeführt.

Besonders bevorzugt kann das Widerstandselement mit der ersten und/oder zweiten Halbleiterlichtquelle und damit mit der zumindest einen ersten und/oder zweiten LED in thermischem Kontakt stehen. Dadurch kann zwischen dem Widerstandselement und zumindest der ersten und/oder zweiten Halbleiterlichtquelle Wärmeenergie ausgetauscht werden, so dass das Widerstandselement und zumindest die erste und/oder zweite Halbleiterlichtquelle die gleiche oder eine ähnliche Temperatur aufweisen oder zumindest ähnliche Temperaturänderungen bei Änderungen der Umgebungstemperatur oder einer Betriebstemperatur zumindest einer der Komponenten der optoelektronischen Vorrichtung, also beispielsweise einer Halbleiterlichtquelle und/oder des Widerstandselements, aufweisen. Das kann insbesondere auch bedeuten, dass sich die Temperatur des Widerstandselements bei einer Temperaturänderung der ersten und/oder zweiten Halbleiterlichtquelle im selben Maße ändert wie die Temperatur der ersten und/oder zweiten Halbleiterlichtquelle und umgekehrt.

Durch die unterschiedlichen ersten und zweiten Temperaturabhängigkeiten der ersten und zweiten Intensität und/oder den ersten und zweiten Wellenlängenbereiche können sich bei in Abhängigkeit von der Umgebungs- und Betriebstemperatur die Leuchteindrücke der ersten und zweiten Halbleiterlichtquelle verschieden voneinander ändern. Bei einer ungeregelten Überlagerung des Lichts der ersten und zweiten Halbleiterlichtquelle kann sich somit der Leuchteindruck der Überlagerung, also des Mischlichts, ebenfalls ändern. Durch das Widerstandselement kann es bei der vorliegenden optoelektronischen Vorrichtung möglich sein, ein Mischlicht zu erzeugen, das hinsichtlich seines Farborts eine möglichst geringe Temperaturabhängigkeit aufweist.

Im Gegensatz zur vorliegenden optoelektronischen Vorrichtung werden zur Stabilisierung des Farborts üblicherweise Sensoren zusammen mit Regelschleifen zur Steuerung von mehreren LEDs eingesetzt. Die Sensoren können dabei optischer Natur sein oder auch die Temperatur einer LED wiedergeben. Die Sensorsignale werden dann in der Regelschleife beispielsweise mithilfe eines Mikrokontrollers ausgewertet und beispielsweise auch unter Zuhilfenahme von tabellierten Daten oder anderen Chipmodellen verarbeitet, um die LEDs entsprechend zu steuern. Die LEDs werden dazu üblicherweise in verschiedenen Regelkreisen oder -strängen verschaltet. Jedoch werden bei derartigen bekannten Techniken unter Umständen auch gegenüber äußeren Störungen anfällige Elektronikkomponenten in aufwändigen und kostenintensiven Schaltungen verwendet. Weiterhin sind die sensorabhängigen Regelschleifen typischerweise unter Volllast am effizientesten, während die Regelung bei gedimmten LEDs, was die Regelung mit sich bringen würde, im Allgemeinen nicht die volle Effizienz erreicht.

Bei der hier beschriebenen optoelektronischen Vorrichtung ist das Widerstandselement im Hauptstromkreis angeordnet, also in dem Stromkreis, mittels dem die erste und zweite Halbleiterlichtquelle betrieben werden. Dadurch, dass bei der hier beschriebenen optoelektronischen Vorrichtung das Widerstandselement zumindest mit der ersten Halbleiterlichtquelle in thermischen Kontakt steht und mit dieser in Serie verschaltet ist, kann die an der ersten Halbleiterlichtquelle abfallende Spannung und der durch die erste Halbleiterlichtquelle fließende Strom direkt durch das Widerstandselement beeinflusst werden. Damit stellt das Widerstandselement, das direkt im Hauptstromkreis verschaltet ist, gleichzeitig auch das regelnde Element dar. Durch die Parallelschaltung der zweiten Halbleiterlichtquelle zur Serienschaltung mit dem Widerstandselements und der ersten Halbleiterlichtquelle kann weiterhin auch der durch die zweite Halbleiterlichtquelle fließende Strom beeinflusst werden. Mit anderen Worten wird die Strombalance in der Parallelschaltung, die das Kernelement der optoelektronischen Vorrichtung bildet, beeinflusst von den Temperaturkennlinien der ersten und zweiten Halbleiterlichtquelle in Kombination mit der Temperaturkennlinie des Widerstandselements, das eine definierte Temperaturabhängigkeit hat. Dadurch kann eine temperaturabhängige Änderung der ersten und zweiten Intensität hervorgerufen werden, die beispielsweise der ersten und zweiten Temperaturabhängigkeit des ersten beziehungsweise zweiten Wellenlängenbereichs und/oder der ersten beziehungsweise zweiten Intensität entgegen wirken kann. Insbesondere kann es möglich sein, dass das die temperaturabhängige Variation des Farborts des von der optoelektronischen Vorrichtung abgestrahlten Mischlichts eine geringere Temperaturabhängigkeit aufweist als durch die erste und zweite Temperaturabhängigkeit vorgegeben ist. Eine aufwändige und fehleranfällige Regelschleife, wie sie üblicherweise eingesetzt wird, kann bei der vorliegenden optoelektronischen Vorrichtung entfallen.

Eine LED einer Halbleiterlichtquelle, also etwa die erste und/oder die zweite LED, kann insbesondere eine Epitaxieschichtenfolge, also eine epitaktisch gewachsene Halbleiterschichtenfolge, aufweisen. Dabei kann die LED beispielsweise auf der Basis von InGaAlN ausgeführt sein. Unter InGaAlN-basierte LEDs und Halbleiterschichtenfolgen fallen insbesondere solche, bei denen die epitaktisch hergestellte Halbleiterschichtenfolge in der Regel eine Schichtenfolge aus unterschiedlichen Einzelschichten aufweist, die mindestens eine Einzelschicht enthält, die ein Material aus dem III-V-Verbindungshalbleitermaterialsystem $In_xAl_yGa_{1-x-y}N$ mit $0 \leq x \leq 1$, $0 \leq y \leq 1$ und $x + y \leq 1$ aufweist. Halbleiterschichtenfolgen, die zumindest eine aktive Schicht auf Basis auf InGaAlN aufweisen, können beispielsweise bevorzugt elektromagnetische Strahlung in einem ultravioletten bis grünen Wellenlängenbereich emittieren.

Alternativ oder zusätzlich kann die LED auch auf InGaAlP basieren, das heißt, dass die LED unterschiedliche Einzelschichten aufweisen kann, wovon mindestens eine Einzelschicht ein Material aus dem III-V-Verbindungshalbleitermaterialsystem $In_xAl_yGa_{1-x-y}P$ mit $0 \leq x \leq 1$, $0 \leq y \leq 1$ und $x + y \leq 1$ aufweist. Halbleiterschichtenfolgen oder LEDs, die zumindest eine aktive Schicht auf Basis von InGaAlP aufweisen, können beispielsweise bevorzugt elektromagnetische Strahlung mit einer oder mehreren spektralen Komponenten in einen grünen bis roten Wellenlängenbereich emittieren.

Alternativ oder zusätzlich können die Halbleiterschichtenfolge oder LED auch andere III-V-Verbindungshalbleitermaterialsysteme wie etwa ein AlGaAs-basiertes Material oder ein II-VI-Verbindungshalbleitermaterialsysteme aufweisen. Insbesondere kann eine LED, die ein AlGaAs-basiertes Material aufweist, geeignet sein, elektromagnetische Strahlung mit einer oder mehreren spektralen Komponenten in einem roten bis infraroten Wellenlängenbereich zu emittieren. Ein II-VI-Verbindungshalbleitermaterial kann wenigstens ein Element aus der zweiten Hauptgruppe oder der zweiten Nebengruppe, wie beispielsweise Be, Mg, Ca, Sr, Cd, Zn, Sn, und ein Element aus der sechsten Hauptgruppe, wie beispielsweise O, S, Se, Te, aufweisen. Insbesondere umfasst ein II-VI-Verbindungs-Halbleitermaterial eine binäre, ternäre oder quaternäre Verbindung, die wenigstens ein Element aus der zweiten Hauptgruppe oder zweiten Nebengruppe und wenigstens ein Element aus der sechsten Hauptgruppe umfasst. Eine solche binäre, ternäre oder quaternäre Verbindung kann zudem beispielsweise ein oder mehrere Dotierstoffe sowie zusätzliche Bestandteile aufweisen. Beispielsweise gehören zu den II-VI-Verbindungs-Halbleitermaterialien: ZnO, ZnMgO, CdS, ZnCdS, MgBeO.

Die Halbleiterschichtenfolge der ersten und/oder der zweiten LED kann weiterhin ein Substrat aufweisen, auf dem die oben genannten III-V- oder II-VI-Verbindungshalbleitermaterialien abgeschieden sind. Das Substrat kann dabei ein Halbleitermaterial, beispielsweise ein oben genanntes Verbindungshalbleitermaterialsystem, umfassen. Insbesondere kann das Substrat Saphir, GaAs, GaP, GaN, InP, SiC, Si und/oder Ge umfassen oder aus einem solchen Material sein. Die Halbleiterschichtenfolge kann als aktiven Bereich beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Struktur) aufweisen. Die Bezeichnung Quantentopfstruktur umfasst im Rahmen der Anmeldung insbesondere jegliche Struktur, bei der Ladungsträger durch Einschluss ("confinement") eine Quantisierung ihrer Energiezustände erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen. Die Halbleiterschichtenfolge kann neben dem aktiven Bereich weitere funktionale Schichten und funktionelle Bereiche umfassen, etwa p- oder n-dotierte Ladungsträgertransportschichten, also Elektronen- oder Löchertransportschichten, undotierte oder p- oder n-dotierte Confinement-, Cladding- oder Wellenleiterschichten, Barriereschichten, Planarisierungsschichten, Pufferschichten, Schutzschichten und/oder Elektroden sowie Kombinationen daraus. Solche Strukturen den aktiven Bereich oder die weiteren funktionalen Schichten und Bereiche betreffend sind dem Fachmann insbesondere hinsichtlich Aufbau, Funktion und Struktur bekannt und werden von daher an dieser Stelle nicht näher erläutert.

Die erste und/oder die zweite LED können beispielsweise auch als Dünnfilm-Leuchtdioden-Chips ausgeführt sein. Ein Dünnfilm-Leuchtdioden-Chip zeichnet sich insbesondere durch eines oder mehrere der folgenden charakteristischen Merkmale aus:

- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von $20\mu m$ oder weniger, insbesondere im Bereich von 10 $\mu m$ auf; und/oder
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf. Die Epitaxieschichtenfolge eines Dünnfilm-Leuchtdioden-Chips kann nach dem Aufwachsen auf einem Aufwachssubstrat durch Umbonden auf ein als Trägerelement ausgebildetes Trägersubstrat übertragen sein.

Weiterhin kann die erste und/oder die zweite Halbleiterlichtquelle und damit die wenigstens eine erste und/oder zweite LED einen mischfarbigen und insbesondere beispielsweise einen weißen Leuchteindruck erwecken. Dazu kann die erste und/oder zweite LED einen Wellenlängenkonversionsstoff aufweisen, der in Form eines Vergusses oder einer Oberflächenbeschichtung auf oder über der Epitaxieschichtenfolge der ersten und/oder zweiten LEDs aufgebracht sein kann. Der Wellenlängenkonversionsstoff kann geeignet sein, zumindest einen Teil des von einer LED emittierten Lichts, das etwa in einem ultravioletten bis blauen Spektralbereich liegen kann, in langwelligeres Licht zu konvertieren, also etwa in Licht mit einer oder mehreren spektralen Komponenten in einem grünen und/oder einem gelben und/oder einem roten Wellenlängenbereich. Durch die Überlagerung des emittierten Lichts mit dem konvertierten Lichts kann ein mischfarbiger, beispielsweise weißer, Leuchteindruck erzeugt werden.

Der Wellenlängenkonversionsstoff kann einen oder mehrere der folgenden Materialien aufweisen: Granate der Seltenen Erden und der Erdalkalimetalle, beispielsweise YAG:Ce$^{3+}$, Nitride, Nitridosilikate, Sione, Sialone, Aluminate, Oxide, Halophosphate, Orthosilikate, Sulfide, Vanadate, Perylene, Coumarin und Chlorosilikate. Weiterhin kann der Wellenlängenkonversionsstoff auch geeignete Mischungen und/oder Kombinationen daraus umfassen. Weiterhin kann der Wellenlängenkonversionsstoff in einem transparenten Matrixmaterial eingebettet sein, das den Wellenlängenkonversionsstoff umgibt oder enthält. Das transparente Matrixmaterial kann beispielsweise Silikone, Epoxide, Acrylate, Imide, Carbonate, Olefine oder Derivate davon in Form von Monomeren, Oligomeren oder Polymeren als Mischungen, Copolymere oder Verbindungen damit aufweisen. Beispielsweise kann das Matrixmaterial ein Epoxidharz, Polymethylmethacrylat (PMMA) oder ein Silikonharz sein.

Weiterhin kann das von der ersten und/oder zweiten Halbleiterlichtquelle beziehungsweise der ersten und/oder zweiten LED erzeugte Licht allein durch die Wahl der Materialien der Epitaxieschichtenfolgen ohne Verwendung eines Wellenlängenkonversionsstoffs bestimmt sein. Beispielsweise kann die erste Halbleiterlichtquelle einen weißen Leuchteindruck in Kombination mit einem Wellenlängenkonversionsstoff erwecken, während die zweite Halbleiterlichtquelle einen farbigen Leuchteindruck erwecken kann. So kann die erste Halbleiterlichtquelle beispielsweise eine erste LED auf Basis von InGaN aufweisen, die Licht in einem blauen Wellenlängenbereich emittiert. Weiterhin kann die erste LED einen Wellenlängenkonversionsstoff aufweisen, der einen Teil des blauen Primärlichts in grünes, gelbes oder gelb-grünes Sekundärlicht konvertiert, so dass der ersten Wellenlängenbereich blaue und grüne, gelbe oder gelb-grüne spektrale Komponenten umfasst und einen grünlichweißen bis kaltweißen Farbeindruck erweckt. Die zweite Halbleiterlichtquelle kann eine zweite LED auf Basis von InGaAlP aufweisen, die Licht in einem zweiten, roten Wellenlängenbereich abstrahlt. Durch Überlagerung des Lichts mit dem ersten und zweiten Wellenlängenbereich kann je nach gewünschter Gewichtung ein warmweißer Leuchteindruck durch das Mischlicht der optoelektronischen Vorrichtung erweckt werden. Alternativ dazu kann die zweite Halbleiterlichtquelle auch eine zweite LED auf Basis von InGaAlP aufweisen, die Licht in einem zweiten, gelben Wellenlängenbereich erzeugt, so dass die optoelektronische Vorrichtung ein Mischlicht mit einem kaltweißen Leuchteindruck abstrahlen kann. Bei derartigen optoelektronischen Vorrichtungen kann bei einer vorgegebenen Umgebungs- und Betriebstemperatur durch die erste Halbleiterlichtquelle eine grobe Vorauswahl des gewünschten Farborts möglich sein, während eine Feineinstellung beziehungsweise ein "Feintuning" des Farborts durch die zweite Halbleiterlichtquelle möglich ist. Alternativ können die erste und zweite Halbleiterlichtquelle umgekehrt hinsichtlich der vorher beschriebenen Wellenlängenbereiche und Farbeindrücke ausgeführt sein. Weiterhin kann die erste Halbleiterlichtquelle und/oder die zweite Halbleiterlichtquelle jeweils eine Mehrzahl von ersten beziehungsweise zweiten LEDs aufweisen, die jeweils gleich ausgeführt sind.

Lichtemittierende Dioden weisen üblicherweise eine negative Temperaturabhängigkeit der Intensität in typischen Umgebungs- und Betriebstemperaturen im Bereich von -40°C bis 125°C auf. Das bedeutet, dass die Intensität des abgestrahlten Lichts bei gleich bleibenden elektrischen Bedingungen mit steigender Umgebungs- und Betriebstemperatur sinkt. Je nach Ausführung und Materialwahl einer LED kann dabei die Intensität des von einer LED abgestrahlten Lichts von 100% bei einer Temperatur von 0°C auf eine Intensität von kleiner oder gleich 90% bis größer oder gleich 10% bei einer Temperatur von 100°C abfallen.

Je nach Ausführung und Materialwahl kann die erste Temperaturabhängigkeit kleiner als die zweite Temperaturabhängigkeit sein, das bedeutet, dass sich mit steigender Temperatur beispielsweise die erste Intensität der ersten Halbleiterlichtquelle weniger ändert als die zweite Intensität der zweiten Halbleiterlichtquelle. In diesem Fall ist das Widerstandelement ein Widerstandselement mit einem positiven Temperaturkoeffizienten, das bedeutet, dass der elektrische Widerstand des Widerstandselements mit steigender Temperatur ansteigt und das Widerstandselement als so genannter Kaltleiter oder PTC-("positve temperature coefficient"-)Element ausgeführt ist. Steigen die Temperaturen der ersten und zweiten Halbleiterlichtquelle beispielsweise durch einen Anstieg der Umgebungstemperatur an, so verringert sich im vorgenannten Fall die zweite Intensität stärker als die erste Intensität. Das bedeutet, dass der Farbort des Mischlichts zum Farbort der ersten Halbleiterlichtquelle hin verschoben würde. Durch das als PTC-Element ausgeführte Widerstandselement steigt aber gleichzeitig auch die Temperatur und damit auch der elektrische Widerstand an, so dass der durch die Serienschaltung und damit durch die erste Halbleiterlichtquelle fließende Strom im Vergleich zum durch die zweite Halbleiterlichtquelle fließenden Strom verringert wird, so dass der rein temperaturbedingten Änderung der ersten und zweiten Intensität entgegen gewirkt werden kann.

Alternativ dazu kann die erste Temperaturabhängigkeit größer als die zweite Temperaturabhängigkeit sein. In diesem Fall ist das Widerstandselement ein Widerstandselement mit einem negativen Temperaturkoeffizienten, das bedeutet, das der elektrische Widerstand des Widerstandselements mit steigender Temperatur abnimmt und das Widerstandselement als so genannter Heißleiter oder NTC-("negative temperature coefficient"-)Element ausgeführt ist. Dadurch kann wie beim vorherigen Fall ebenfalls der rein temperaturbedingten Änderung der ersten und zweiten Intensität entgegen gewirkt werden, indem bei einem Temperaturanstieg der durch die Serienschaltung und damit durch die erste Halbleiterlichtquelle fließende Strom im Vergleich zum durch die zweite Halbleiterlichtquelle fließenden Strom erhöht wird.

Insbesondere kann das Widerstandelement einen temperaturabhängigen elektrischen Widerstand aufweisen, der an die erste und zweite Temperaturabhängigkeit der ersten beziehungsweise zweiten Halbleiterlichtquelle angepasst ist. Dies kann insbesondere bedeuten, dass das Widerstandselement kein Schaltverhalten aufweist und dass sich der elektrische Widerstand nicht sprunghaft in einem Temperaturbereich von -40°C bis 125°C ändert. Bevorzugt variiert der elektrische Widerstand des Widerstandselements in einem Temperaturbereich von größer oder gleich -40°C und kleiner oder gleich 125°C kontinuierlich, das bedeutet, dass der elektrische Widerstand je nach Ausführung des Widerstandselements als Kaltleiter oder Heißleiter mit einer im Wesentlichen gleich bleibenden Temperaturabhängigkeit steigt beziehungsweise fällt. Bevorzugt weist das Widerstandselement eine lineare oder annähernd lineare Widerstands-Temperatur-Abhängigkeit auf.

Beispielsweise kann ein als Kaltleiter ausgeführtes Widerstandselement Platin oder geeignet dotiertes Silizium aufweisen. Ein als Heißleiter ausgeführtes Widerstandselement kann beispielsweise ein oder mehrere Oxide, etwa in Form einer Oxidkeramik, mit Mangan, Nickel, Kobalt, Eisen, Kupfer und/oder Titan aufweisen.

Weiterhin kann die optoelektronische Vorrichtung eine dritte Halbleiterlichtquelle aufweisen, die mit der Parallelschaltung in Serie geschaltet ist und die zumindest eine weitere LED aufweist. Bevorzugt ist die zumindest eine weitere LED zumindest eine erste LED. Die dritte Halbleiterlichtquelle kann geeignet sein, den Farbort des Mischlichts der optoelektronischen Vorrichtung auf einen gewünschten Wert bei einer vorgewählten Betriebs- und Umgebungstemperatur einzustellen. Dazu kann die dritte Halbleiterlichtquelle zusätzlich oder alternativ auch zumindest eine dritte LED aufweisen, die geeignet ist, im Betrieb Licht in einem dritten Wellenlängenbereich abzustrahlen, der verschieden vom ersten und zweiten Wellenlängenbereich ist. Durch die Serienverschaltung der Parallelschaltung mit der dritten Halbleiterlichtquelle ist letztere im Wesentlichen unbeeinflusst von der Regelung durch das Widerstandselement in der Parallelschaltung. Somit kann bei der vorliegenden optoelektronischen Vorrichtung eine gezielte temperaturabhängige Regelung der ersten und zweiten Halbleiterlichtquelle möglich sein, während die dritte Halbleiterlichtquelle nicht aktiv geregelt sondern "freilaufend" betrieben wird.

Weiterhin kann die optoelektronische Vorrichtung zumindest ein elektronisches Bauelement aufweisen, das geeignet ist, das Mischlicht bei einer vorgewählten Umgebungs- und Betriebstemperatur der optoelektronischen Vorrichtung einzustellen. Das elektronische Bauelement kann dazu in die Parallelschaltung integriert sein, also mit der Parallelschaltung in Serie oder parallel verschaltet sein, oder auch ein Element der dritten Halbleiterlichtquelle sein. Das elektronische Bauelement kann dabei eines oder mehrere Elemente aufweisen, die geeignet sind, den der ersten, zweiten und/oder gegebenenfalls dritten Halbleiterlichtquelle aufgeprägten Strom für eine vorgewählte Betriebs- und Umgebungstemperatur einzustellen. Das elektronische Bauelement kann gewählt werden aus einem oder mehreren Festwiderständen, einem oder mehreren einstellbaren Widerständen wie etwa Potentiometern, einem oder mehreren Transistoren wie etwa MOSFETs sowie Kombinationen und Verschaltungen daraus.

Durch das zumindest eine elektronische Bauelement und/oder die dritte Halbleiterlichtquelle kann das Mischlicht für eine bestimmte Umgebungs- und Betriebstemperatur eingestellt werden, ohne dass das elektronische Bauelement oder die dritte Halbleiterlichtquelle an der eigentlichen temperaturabhängigen Regelung durch das Widerstandselement beteiligt sind. Das zumindest eine elektronische Bauelement kann insbesondere auch geeignet sein, das relative Intensitätsverhältnis des von der Parallelschaltung abgestrahlten Lichts und des von der dritten Halbleiterlichtquelle abgestrahlten Lichts bei einer vorgewählten Temperatur einzustellen. Alternativ oder zusätzlich kann durch ein elektronisches Bauelement in der dritten Halbleiterlichtquelle gegebenenfalls eine Einstellung eines relativen Intensitätsverhältnisses der ersten lichtemittierenden Diode und der dritten lichtemittierenden Diode in der dritten Halbleiterlichtquelle bei einer vorbestimmten Temperatur möglich sein.

Die optoelektronische Vorrichtung kann ein Gehäuse oder eine Leiterplatte aufweisen, in dem beziehungsweise auf dem die erste Halbleiterlichtquelle und das Widerstandselement angeordnet sind. Das Gehäuse kann einen Kunststoff aufweisen, insbesondere ein Thermoplast oder ein Duroplast. Beispielsweise kann das Gehäuse durch einen Formprozess wie etwa Spritzpressen, Spritzgießen, Formpressen, Schneiden, Sägen, Fräsen oder eine Kombination daraus herstellbar sein. Der Kunststoff kann dabei Siloxan und/oder Epoxid-Gruppen aufweisen und etwa als Silikon, Epoxidharz oder ein Hybridmaterial aus einer Mischung oder einem Copolymer aus Silikon und Epoxid ausgebildet sein. Alternativ oder zusätzlich kann der Kunststoff auch Polymethylmethacrylat (PMMA), Polyacrylat, Polycarbonat und/oder Imidgruppen aufweisen.

Das Gehäuse kann eine Vertiefung aufweisen, in der zumindest die erste Halbleiterlichtquelle angeordnet ist und über die das Licht im ersten Wellenlängenbereich abgestrahlt werden kann. Das Widerstandselement kann ebenfalls in der Vertiefung angeordnet sein oder auch alternativ dazu vom Gehäusematerial umschlossen sein.

Das Gehäuse kann weiterhin einen Leiterrahmen zur elektrischen Kontaktierung der erster Halbleiterlichtquelle und des Widerstandselements aufweisen. Der Leiterrahmen kann dabei in das Gehäuse integriert sein, wobei der Leiterrahmen vom Gehäusekörper umformt, umgeben und/oder von diesem umgossen ist. Der Leiterrahmen einen oder mehrere Montagebereiche aufweisen, auf dem oder denen die erste Halbleiterlichtquelle und das Widerstandselement aufgebracht werden können. Der Leiterrahmen kann dabei eine Mehrzahl elektrischer Anschlussmöglichkeiten zur elektrischen Kontaktierung der ersten Halbleiterlichtquelle und des Widerstandselements aufweisen, die etwa als Bondpads oder als Montageflächen ausgebildet sind. Mittels des Montagebereichs beziehungsweise der Montagebereiche können dabei insbesondere eine Serienverschaltung sowie auch ein elektrischer Anschluss der ersten Halbleiterlichtquelle und des Widerstandselements an eine externe Strom- und Spannungsversorgung möglich sein. Der Montagebereich kann beispielsweise als Montagefläche auf dem Leiterrahmen ausgebildet sein.

Weiterhin kann auch die zweite Halbleiterlichtquelle zusammen mit der ersten Halbleiterlichtquelle und dem Widerstandselement in demselben Gehäuse angeordnet sein. Alternativ dazu kann die optoelektronische Vorrichtung ein erste Gehäuse mit der ersten Halbleiterlichtquelle und dem Widerstandselement und zusätzlich ein zweites Gehäuse aufweisen, in dem die zweite Halbleiterlichtquelle angeordnet ist. Insbesondere können das erste Gehäuse und das zweite Gehäuse dann in thermischem Kontakt zueinander stehen, so dass eine thermische Kopplung zwischen den ersten und zweiten LEDs und dem Widerstandselement vorliegen kann. Weist die optoelektronische Vorrichtung eine dritte Halbleiterlichtquelle und/oder zumindest ein elektronisches Bauelement auf, so können diese ebenfalls in demselben Gehäuse wie die erste Halbleiterlichtquelle und das Widerstandselement, alternativ dazu außerhalb dieses oder auch in einem weiteren Gehäuse angeordnet sein.

Die erste Halbleiterlichtquelle kann mit dem Widerstandselement über einen Wärmeleiter in thermischen Kontakt stehen. Beispielsweise kann der Wärmeleiter ein thermisch gut leitendes Material wie etwa Kupfer aufweisen. Der Wärmeleiter kann beispielsweise auch durch einen Leiterrahmen eines Gehäuses gebildet werden. Durch den Wärmeleiter kann weiterhin auch eine elektrische Verschaltung zwischen der ersten Halbleiterlichtquelle und dem Widerstandselement ermöglicht werden. Das Widerstandselement kann dabei als diskretes elektronisches Bauteil ausgeführt sein. Durch den Wärmeleiter können Selbsterwärmungseffekte im Widerstandselement minimiert werden und das Widerstandselement kann bevorzugt die gleiche Temperatur wie die erste Halbleiterlichtquelle aufweisen. Ferner kann auch die zweite Halbleiterlichtquelle über denselben Wärmeleiter oder einen weiteren Wärmeleiter thermisch an die erste Halbleiterlichtquelle und das Widerstandselement gekoppelt sein, so dass besonders bevorzugt die erste Halbleiterlichtquelle, die zweite Halbleiterlichtquelle und das Widerstandselement dieselbe Temperatur aufweisen.

Die erste Halbleiterlichtquelle kann auch direkt auf dem Widerstandselement aufgebracht sein. Dazu kann das Widerstandselement beispielsweise als Trägerelement, etwa als so genannter "Submount", ausgebildet sein. Der elektrische Kontakt für die Serienschaltung kann dadurch direkt über die Verbindungsfläche zwischen dem Widerstandselement und der ersten Halbleiterlichtquelle ausgebildet sein.

Weiterhin kann das Widerstandselement auch als Trägersubstrat für eine oder mehrere erste LEDs der ersten Halbleiterlichtquelle ausgebildet sein. Dadurch kann das Widerstandselement direkt in die erste Halbleiterlichtquelle integriert sein, so dass ein optimaler Wärmekontakt zwischen der oder den ersten LEDs und dem Widerstandselement erreicht werden kann. Besonders geeignet dafür kann ein hinsichtlich der temperaturabhängigen Leitfähigkeit geeignet dotiertes Silizium-Trägersubstrat sein, das gleichzeitig als PTC-Widerstandselement ausgeführt ist.

Die hier beschriebene optoelektronische Vorrichtung kann insbesondere derart ausgeführt sein, dass ein Mischlicht abgestrahlt werden kann, das in einem Temperaturbereich von größer oder gleich 0°C und kleiner oder gleich 100°C und bevorzugt von größer oder gleich -40°C und kleiner oder gleich 125°C eine temperaturabhängige Farbortverschiebung um einen mittleren Farbort aufweist, die entlang einer Hauptachse einer MacAdams-Ellipse um den mittleren Farbort herum verläuft. Dabei können die Farbortverschiebung und der mittlere Farbort durch einen ersten Farbort des bei einer Temperatur der optoelektronischen Vorrichtung von beispielsweise 0°C emittierten Mischlichts und durch einen zweiten Farbort des bei einer Temperatur von beispielsweise 100°C emittierten Mischlichts charakterisiert sein. Die temperaturabhängige Farbortverschiebung kann dann in erster Näherung durch die Verbindungslinie zwischen dem ersten und zweiten Farbort charakterisierbar sein. "Entlang der Hauptachse" bedeutet in diesem Zusammenhang, dass die geometrische Projektion dieser Verbindungslinie auf die Hauptachse der MacAdams-Ellipse länger ist als die Projektion der Verbindungslinie auf die Nebenachse derselben MacAdams-Ellipse. Besonders bevorzugt verlaufen die Verbindungslinie und damit auch die Farbortverschiebung des Mischlichts parallel oder zumindest annähernd parallel zur Hauptachse der zugehörigen MacAdams-Ellipse. Farbortverschiebungen, die entlang der Hauptachse einer MacAdams-Ellipse verlaufen, sind schwerer wahrnehmbar als solche, die mit einem zahlenmäßig gleichen Farbortkoordinatenunterschied entlang der Nebenachse der MacAdams-Ellipse verlaufen.

Weitere Vorteile und vorteilhafte Ausführungsformen und Weiterbildungen der Erfindung ergeben sich aus den im Folgenden in Verbindung mit den Figuren 1 bis 17 beschriebenen Ausführungsformen.

Es zeigen:

Figuren 1A bis 2 schematische Darstellungen der CIE-Normfarbtafel,
Figuren 3A und 3B Graphen von Temperaturabhängigkeiten von ersten und zweiten LEDs gemäß einem Ausführungsbeispiel,
Figuren 4 bis 11 schematische Darstellungen von optoelektronischen Vorrichtungen gemäß weiteren Ausführungsbeispielen,
Figuren 12 bis 14 Graphen mit Simulationen zu Regelungseigenschaften von optoelektronischen Vorrichtungen gemäß weiteren Ausführungsbeispielen und
Figuren 15 bis 17 schematische Darstellungen von optoelektronischen Vorrichtungen gemäß weiteren Ausführungsbeispielen.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

In den folgenden Ausführungsbeispielen werden erste Halbleiterlichtquellen 1 mit zumindest einer ersten LED 11 beschrieben, die einen kaltweißen bis gelbgrünlichen Leuchteindruck erweckt. Die zumindest eine erste LED 11 weist dazu wie im allgemeinen Teil beschrieben rein beispielhaft eine blau emittierende Epitaxieschichtenfolgen auf InGaN-Basis auf, auf der ein gelb-grün emittierender Wellenlängenkonversionsstoff aufgebracht ist. Die im allgemeinen Teil eingeführte CCT liegt etwa im Bereich von 4000 bis 5500 Kelvin. Um von einer optoelektronischen Vorrichtung abgestrahltes warmweißes Mischlicht zu erzeugen, sind die im Folgenden beschriebenen zweiten Halbleiterlichtquellen 2 mit zumindest einer zweiten LED 21 ausgebildet, die in einem zweiten, roten Wellenlängenbereich Licht emittiert. Jedoch kann aufgrund der typischerweise breiten Emissionsbanden von rot emittierenden Wellenlängenkonversionsstoffen viel Leistung in einem Wellenlängenbereich liegen, in dem die Augenempfindlichkeit sehr gering ist, also in einem Bereich von größer oder gleich etwa 640 Nanometer. Bevorzugt wird für die im Folgenden beschriebenen Ausführungsbeispiele für optoelektronische Vorrichtungen deshalb kein zusätzlicher, beispielsweise rot emittierender Wellenlängenkonversionsstoff verwendet.

Insbesondere wird das Licht mit dem zweiten Wellenlängenbereich durch das Material der Epitaxieschichtenfolge der zumindest einen zweiten LED 21 auf Basis von InGaAlP ohne Verwendung eines zusätzlichen rot emittierenden Wellenlängenkonversionsstoffs erzeugt.

Durch Verwendung von zweiten Halbleiterlichtquellen 2 und zweiten LEDs 21, die rotes Licht direkt erzeugen können, kann der zweite Wellenlängenbereich besser im gut wahrnehmbaren roten Wellenlängenbereich unterhalb von 640 Nanometer gewählt werden. Dadurch kann für die im Folgenden beschriebenen optoelektronischen Vorrichtungen eine hohe Effizienz bei einem gleichzeitig hohen Farbwiedergabewert durch die Kombinationen der gezeigten weiß emittierenden ersten Halbleiterlichtquellen 1 und rot emittierenden zweiten Halbleiterlichtquellen 2 erreicht werden.

Alternativ zu den hier rein beispielhaft beschriebenen Kombinationen mit weiß emittierenden ersten Halbleiterlichtquellen 1 und direkt rot emittierenden zweiten Halbleiterlichtquellen 2 können aber auch jede andere Kombination von ersten und zweiten Halbleiterlichtquellen mit Emissionsspektren in anderen ersten und zweiten Wellenlängenbereichen verwendet werden, wenn ein anderer Farb- und Leuchteindruck des Mischlichts erwünscht ist.

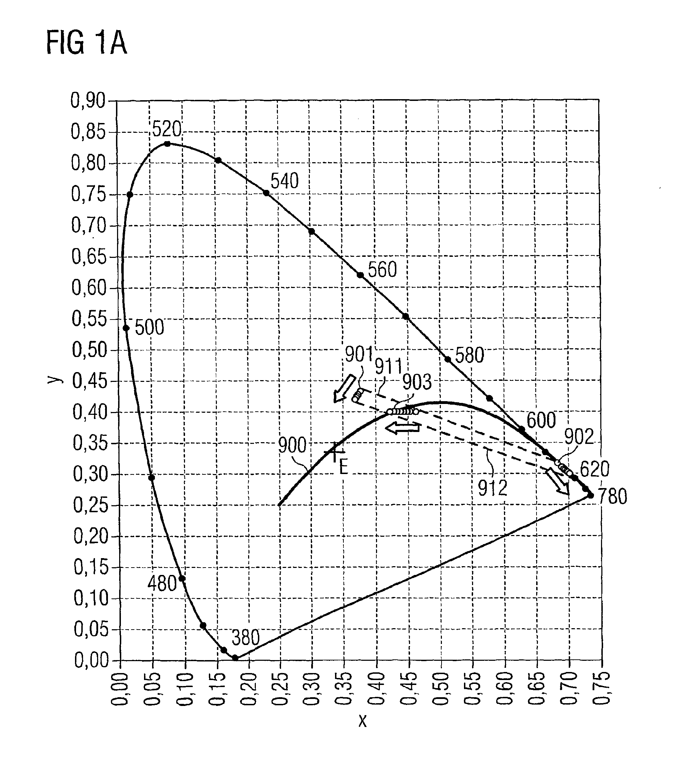

In Figur 1A ist eine dem Fachmann bekannte CIE-Normfarbtafel mit der Farbortkoordinate x auf der horizontalen Achse und der Farbortkoordinate y auf der vertikalen Achse gezeigt. Dabei kennzeichnet die Linie 900 die dem Fachmann bekannte so genannte Weißkurve eines planckschen Schwarzkörperstrahlers bei verschiedenen Temperaturen dieses. Diese Temperaturen werden auch als Farbtemperatur bezeichnet. Das Kreuz E bezeichnet den (mathematischen) Weißpunkt mit den Farbortkoordinaten x = y = 1/3, der in etwa einer Farbtemperatur von 5500 Kelvin entspricht.

Weiterhin sind in Figur 1A die Farborte 901 für die oben beschriebene erste LED 11 mit dem Emissionsspektrum im grünlich-weißen ersten wellenlängenbereich für verschiedene Umgebungstemperaturen von 0°C bis 50°C gekennzeichnet. Durch den Pfeil ist die Farbortänderung für steigende Umgebungstemperaturen zwischen 0°C und 50°C angedeutet. Für die oben beschriebene zweite LED 21 mit dem Emissionsspektrum im roten zweiten Wellenlängenbereich sind die Farborte 902 im selben Temperaturbereich von 0°C bis 50°C eingezeichnet, wobei auch hier die Farbortänderung bei steigenden Umgebungstemperaturen durch den zugehörigen Pfeil angedeutet ist.

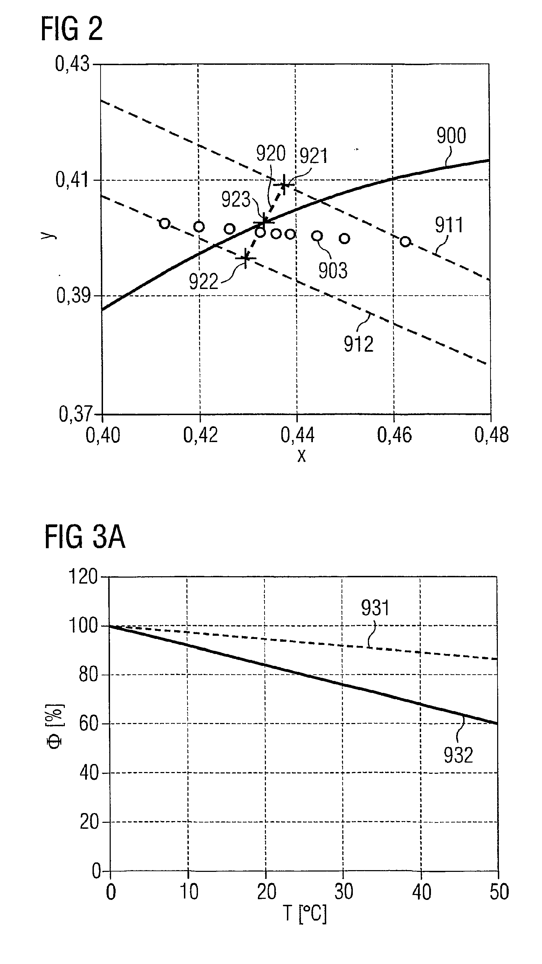

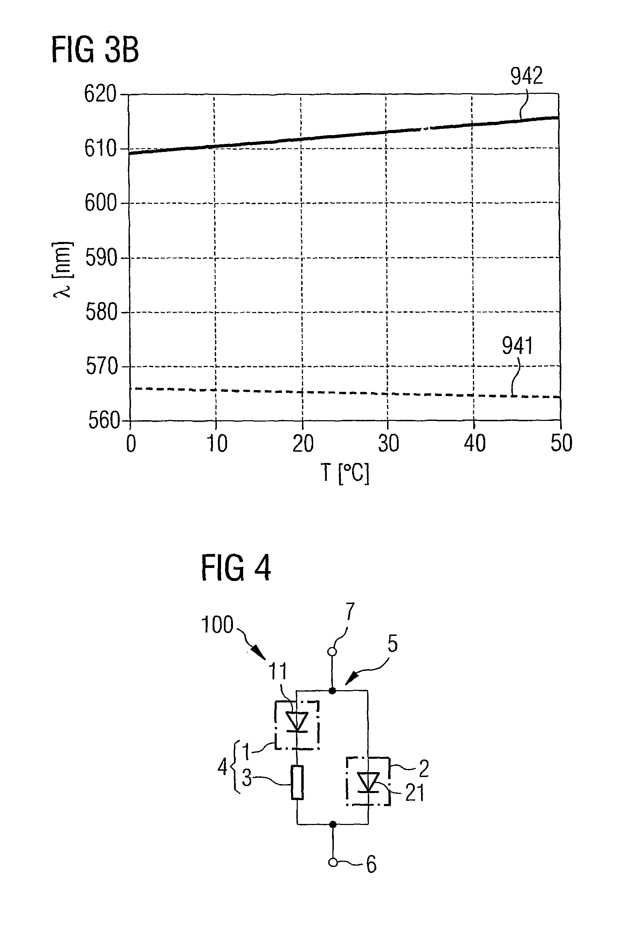

Zusätzlich zur Figur 1A ist in Figur 3A weiterhin die mit der Änderung der Umgebungstemperatur T in Grad Celsius einhergehende Änderung der ersten Intensität für die erste LED 11 mittels der Kurve 931 und der zweiten Intensität für die zweite LED 21 mittels der Kurve 932 in relativen Einheiten gezeigt, wobei hier jeweils ein gleich bleibender Betriebsstrom für die LEDs angenommen wurde. Die Änderung der jeweils dominanten Wellenlänge λ (in Nanometer) des ersten und zweiten Wellenlängenbereichs ist weiterhin auch in Figur 3B für die erste LED 11 durch Kurve 941 und für die zweite LED 21 durch die Kurve 942 in Abhängigkeit von der Umgebungstemperatur T in Grad Celsius gezeigt.

Aus den Figuren 3A und 3B ist zu erkennen, dass sich der zweite Wellenlängenbereich der zweiten, rot emittierenden LED 21 für steigende Umgebungstemperaturen zu größeren Wellenlängen hin verschiebt und das emittierte Licht gleichzeitig um etwa 40% an Intensität verliert. Im Vergleich dazu verschiebt sich der erste Wellenlängenbereich der ersten LED 11 zu etwas kürzeren Wellenlängen, was daran liegt, dass der Wellenlängenkonversionsstoff der ersten LED 11 bei höheren Temperaturen ineffizienter wird. Dadurch kann mehr unkonvertiertes, blaues Licht von der ersten LED abgestrahlt werden. Gleichzeitig verringert sich die abgestrahlte erste Intensität der ersten LED 11 um weniger als 20%. Im gezeigten Ausführungsbeispiel erweist sich somit die erste LED 11 im Vergleich zur zweiten LED 21 als temperaturstabiler und weist eine geringere erste Temperaturabhängigkeit des ersten Wellenlängenbereichs und der ersten Intensität im Vergleich zur zweiten Temperaturanhängigkeit des zweiten Wellenlängenbereichs und der zweiten Intensität auf

Bei jeweils gleich bleibendem Betriebsstrom und einer ungeregelten Überlagerung des von der ersten LED 11 und der zweiten LED 21 emittierten Lichts mit den gezeigten ersten und zweiten Temperaturabhängigkeiten ergibt sich eine Temperaturabhängigkeit des resultierenden Mischlichts mit den Farborten 903 in Figur 1A in dem mittels der Linien 901 und 902 angedeuteten Bereich. Dabei ist zu erkennen, dass sich der Leuchteindruck des Mischlichts von warmweiß bei einer Umgebungstemperatur von 0°C zu kaltweiß bei einer Umgebungstemperatur von 50°C verschiebt.

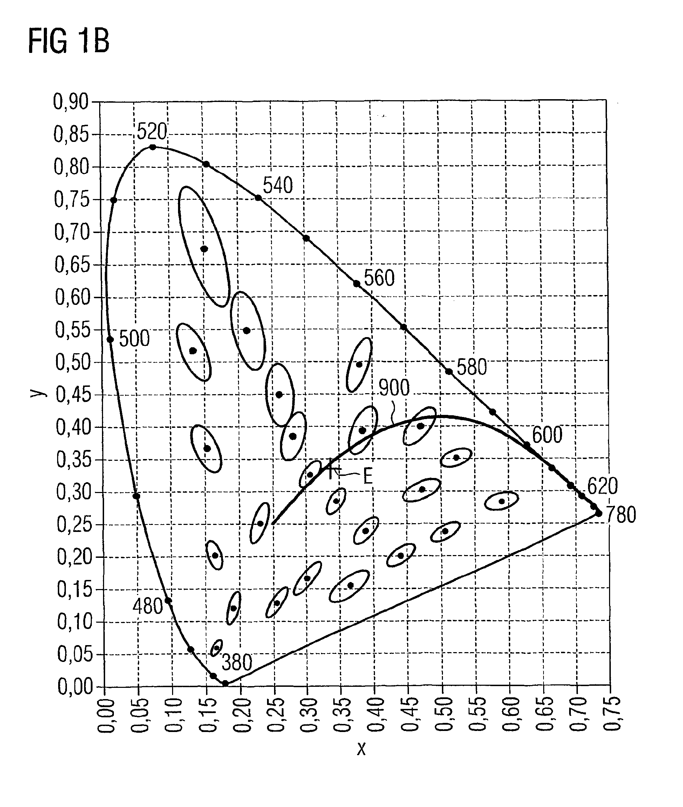

In Figur 2 ist ein Ausschnitt der CIE-Normfarbtafel aus Figur 1A im Bereich der Farbortkoordinate x zwischen 0,40 und 0,48 und im Bereich der Farbortkoordinate y zwischen 0,37 und 043 gezeigt, in dem die Temperaturabhängigkeit der Farborte 903 des ungeregelten Mischlichts deutlicher zu erkennen ist. Davon ausgehend liegt den folgenden Ausführungsbeispielen die Überlegung zugrunde, dass durch eine Regelung des Verhältnisses der ersten Intensität der ersten LED 11 zur zweiten Intensität der zweiten LED 21, bei denen hier und im Folgenden gleiche Temperaturen für alle LEDs angenommen werden, wegen der jeweiligen Temperaturabhängigkeit des ersten und zweiten Wellenlängenbereichs zwar keine Regelung auf einen einzigen Farbort 903 erreicht werden kann. Jedoch kann bei den im Folgenden beschriebenen optoelektronischen Vorrichtungen die Temperaturabhängigkeit der Farborte 903 minimiert werden, wenn die Regelung beispielsweise eine Farbortverschiebung entlang der Verbindungslinie 920 zwischen dem Farbort 921 bei einer Umgebungstemperatur von 0°C und dem Farbort 922 bei einer Umgebungstemperatur von 50°C bewirkt. Dabei ist die Verbindungslinie 920 so gewählt, dass sie entlang der Hauptachse der MacAdams-Ellipse um den Mittelpunkt 923 der Verbindungslinie 920 herum liegt. Einige um das etwa Zehnfache vergrößerte MacAdams-Ellipsen sind zur Verdeutlichung in der CIE-Normfarbtafel in Figur 1B angedeutet. Durch eine Regelung entlang der Hauptachse einer MacAdams-Ellipse kann, wie im allgemeinen Teil ausgeführt, die Wahrnehmbarkeit der Farbortänderung der Farborte 903 des Mischlichts weiter minimiert werden. Die in Figur 2 dargestellte Verbindungslinie 920 ist dabei rein beispielhaft gezeigt. Alternativ dazu sind auch andere Verbindungslinien zwischen einem ersten Punkt auf der Linie 911 und einem zweiten Punkt auf der Linie 912 denkbar, um gewünschte Farbortabhängigkeiten des Mischlichts durch eine entsprechende Regelung und Kompensation der temperaturabhängigen Änderung der ersten und zweiten Intensität zu erreichen.

In Figur 4 ist eine optoelektronische Vorrichtung 100 gemäß einem Ausführungsbeispiel gezeigt. Die optoelektronische Vorrichtung 100 weist eine erste Halbleiterlichtquelle 1 mit einer ersten LED 11 und eine zweite Halbleiterlichtquelle 2 mit einer zweiten LED 21 gemäß der vorangegangenen Beschreibung auf. Die erste Halbleiterlichtquelle 1 bildet zusammen mit einem Widerstandselement 3, das einen temperaturabhängigen elektrischen Widerstand aufweist, eine Serienschaltung 4. Die Serienschaltung 4 bildet mit der zweiten Halbleiterlichtquelle 2 eine Parallelschaltung 5, die über elektrische Anschlüsse 6 und 7 an eine externe Strom- und Spannungsversorgung angeschlossen werden kann. Gemäß der vorherigen Beschreibung weist die erste Halbleiterlichtquelle 1 eine erste Temperaturabhängigkeit der ersten Intensität auf, die kleiner als die zweite Temperaturabhängigkeit der zweiten Intensität ist. Das Widerstandselement ist daher als PTC-Element aus Silizium oder Platin ausgebildet.

Für das gezeigte Ausführungsbeispiel führt die Parallelschaltung der zweiten Halbleiterlichtquelle 2 mit dem als PTC-Element ausgebildeten Widerstandselement 3 zu einer Intensitätsstabilisierung des von der zweiten LED 21 abgestrahlten Lichts. Bei niedrigen Umgebungs- und Betriebstemperaturen fließt mehr Strom über das Widerstandselement 3 und weniger durch die zweite Halbleiterlichtquelle 2, bei hohen Temperaturen verschiebt sich bei konstantem Gesamtstromfluss oder konstanter Spannung zwischen den elektrischen Anschlüssen 6 und 7 die Strombalance hin zur zweiten Halbleiterlichtquelle 2, da durch eine temperaturbedingte Erhöhung des elektrischen Widerstands des Widerstandselements 3 mehr Strom durch die zweite Halbleiterlichtquelle 2 fließt.

Bei einer Parallelschaltung der zweiten Halbleiterlichtquelle 2 nur mit dem Widerstandselement 3 alleine würde jedoch die volle Spannung, die an der zweiten Halbleiterlichtquelle 2 abfällt, auch am Widerstandselement 3 abfallen, was zu hohen ohmschen Verlusten im Widerstandselement 3 und damit zu einer ineffektiven Vorrichtung führen würde. Durch die zusätzliche Serienschaltung 4 des Widerstandselements 3 mit der ersten Halbleiterlichtquelle 1 kann die Verlustleistung am Widerstandselement 3 verringert werden, wodurch sich eine wesentliche Steigerung der Effizienz der optoelektronischen Vorrichtung 100 ergibt. Gleichzeitig zur Erhöhung des Stroms in der zweiten Halbleiterlichtquelle 2 wird durch das Widerstandselement 3 bei steigender Umgebungstemperatur der durch die erste Halbleiterlichtquelle 1 fließende Strom reduziert, so dass im Vergleich zu einem konstanten Betriebstrom für die erste Halbleiterlichtquelle 1 die Strombalance zwischen erster und zweiter Halbleiterlichtquelle 1, 2 durch eine vergleichsweise geringere Stromerhöhung in der zweiten Halbleiterlichtquelle 2 erreicht werden kann. Dies hat wiederum auch zur Folge, dass strombedingte Selbsterwärmungseffekte in der zweiten Halbleiterlichtquelle 2 vergleichsweise niedriger gehalten werden können, wodurch sich eine geringere Wellenlängenverschiebung des von der zweiten LED 21 emittierten Lichts ergibt, als dies bei alleiniger Regelung des Betriebsstroms der zweiten Halbleiterlichtquelle 2 möglich wäre.

Alternativ zum gezeigten und auch den folgenden Ausführungsbeispielen kann das Widerstandselement 3 auch als NTC-Element ausgebildet sein, wenn die erste und zweite Halbleiterlichtquelle 1, 2 derart ausgeführt sind, dass die erste Temperaturabhängigkeit der ersten Intensität größer als die zweite Temperaturabhängigkeit der zweiten Intensität ist. Dies ist beispielsweise der Fall, wenn die erste Halbleiterlichtquelle L dazu eine wie oben beschriebene zweite LED 21 aufweist, während die zweite Halbleiterlichtquelle 2 eine wie oben beschriebene erste LED 11 aufweist.

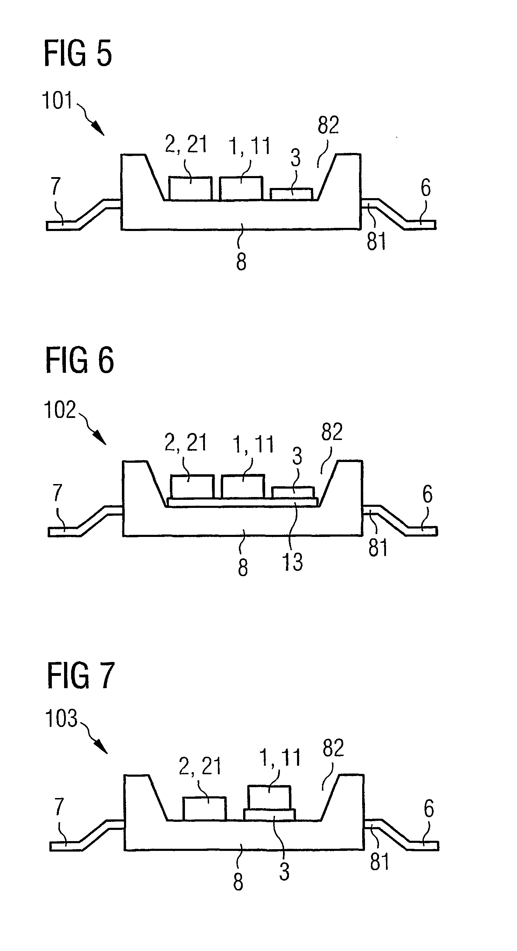

In den Figuren 5 bis 9 sind Ausführungsbeispiele für optoelektronischen Vorrichtungen basierend auf der optoelektronischen Vorrichtung 100 gezeigt.

Die optoelektronische Vorrichtung 101 in Figur 5 weist ein Gehäuse 8 auf, das rein beispielhaft als oberflächenmontierbares Gehäuse ausgeführt ist. Das Gehäuse weist einen Kunststoff auf, etwa Epoxid und/oder Silikon, und kann beispielsweise mittels eines Formprozesses wie im allgemeinen Teil beschrieben hergestellt werden. Weiterhin weist das Gehäuse einen Leiterrahmen 81 zum elektrischen Anschluss der optoelektronischen Vorrichtung 101 auf, der die elektrischen Anschlüsse 6 und 7 umfasst. Der Leiterrahmen 81 ist durch das Kunstoffmaterial des Gehäuses 8 umformt und weist eine geeignete Anschlusstopographie auf, um die Serienschaltung 4 und die Parallelschaltung 5 zu ermöglichen (nicht gezeigt).

Die erste und zweite Halbleiterlichtquelle 1, 2 sowie das als diskretes Bauelement ausgeführte Widerstandselement 3 sind in einer Vertiefung 82 des Gehäuses 8 angeordnet. Weiterhin kann in der Vertiefung 82 beispielsweise ein transparenter Kunststoffverguss zum Schutz der Halbleiterlichtquellen 1, 2 und des Widerstandselements 3 angeordnet sein (nicht gezeigt). Alternativ dazu kann auch das Widerstandselement 3 zusammen mit dem Leiterrahmen 81 bei der Fertigung des Gehäuses 8 mit dem Kunststoffmaterial des Gehäuses 8 umgossen werden, während die Halbleiterlichtquellen 1, 2 nach der Fertigstellung des Gehäuses 8 in der Vertiefung 82 montiert werden. Alternativ dazu können auch die Halbleiterlichtquellen 1, 2 und das Widerstandselement 3 auf dem Leiterrahmen 81 montiert und anschließend mit dem Kunststoffmaterial des Gehäuses 8 umformt werden, wobei das Gehäuse 8 dann auch transparent und ohne Vertiefung 82 ausgeführt sein kann.

Im gezeigten Ausführungsbeispiel stehen die erste Halbleiterlichtquelle 1 und das Widerstandselement 3 und weiterhin auch die zweite Halbleiterlichtquelle 2 durch das Gehäuse 8 und den Leiterrahmen 81 in thermischem Kontakt. Das Gehäuse 8 und insbesondere der Leiterrahmen 81 wirken dabei als Wärmesenke, die eine gleichmäßige Temperaturverteilung der Halbleiterlichtquellen 1, 2 und des Widerstandselements 3 erlauben. Dies ist nötig, um Selbsterwärmungseffekte zu minimieren und das Widerstandselement 3 möglichst den gleichen Temperaturen auszusetzen wie die Halbleiterlichtquellen 1, 2.

Die optoelektronische Vorrichtung 101 weist einen äußert kompakten Aufbau auf, der ohne weitere elektronische Regelungskomponenten, wie sie üblicherweise in Regelkreisen verwendet werden, eine Stabilisierung des Farborts des von der optoelektronischen Vorrichtung 101 abgestrahlten Mischlichts in der vorab und im folgenden beschriebenen Weise ermöglicht.

In Figur 6 ist eine optoelektronische Vorrichtung 102 gemäß einem weiteren Ausführungsbeispiel gezeigt, die die Merkmale des vorherigen Ausführungsbeispiels aufweisen kann, im Vergleich zu diesem aber einen Wärmeleiter 13 umfasst, auf dem die ersten und zweite Halbleiterlichtquelle 1, 2 und das Widerstandselement 3 angeordnet sind. Der Wärmeleiter 13 ist dabei aus Kupfer ausgeführt und erlaubt durch eine geeignete räumliche Strukturierung die erforderliche Serienschaltung 4 und Parallelschaltung 5 der Halbleiterlichtquellen 1, 2 und des Widerstandselements 3. Alternativ dazu kann der Wärmeleiter 13 auch andere Materialien mit einer hohen Wärmeleitfähigkeit aufweisen und beispielsweise auch im Gehäuse 8 integriert sein.

In Figur 7 ist eine weitere optoelektronische Vorrichtung 103 gemäß einem weiteren Ausführungsbeispiel gezeigt, bei der im Vergleich zum Ausführungsbeispiel der Figur 5 die erste Halbleiterlichtquelle 1 direkt auf dem Widerstandselement 3 angeordnet ist. Das Widerstandselement 3 ist dabei als so genannter "Submount" ausgeführt, der eine elektrische Verbindung zwischen dem Leiterrahmen 81 und der ersten Halbleiterlichtquelle 1 ermöglicht. Dadurch können auf einfache Weise die Serienschaltung 4 und gleichzeitig ein guter thermischer Kontakt zwischen der ersten Halbleiterlichtquelle 1 und dem Widerstandselement 3 ermöglicht werden.

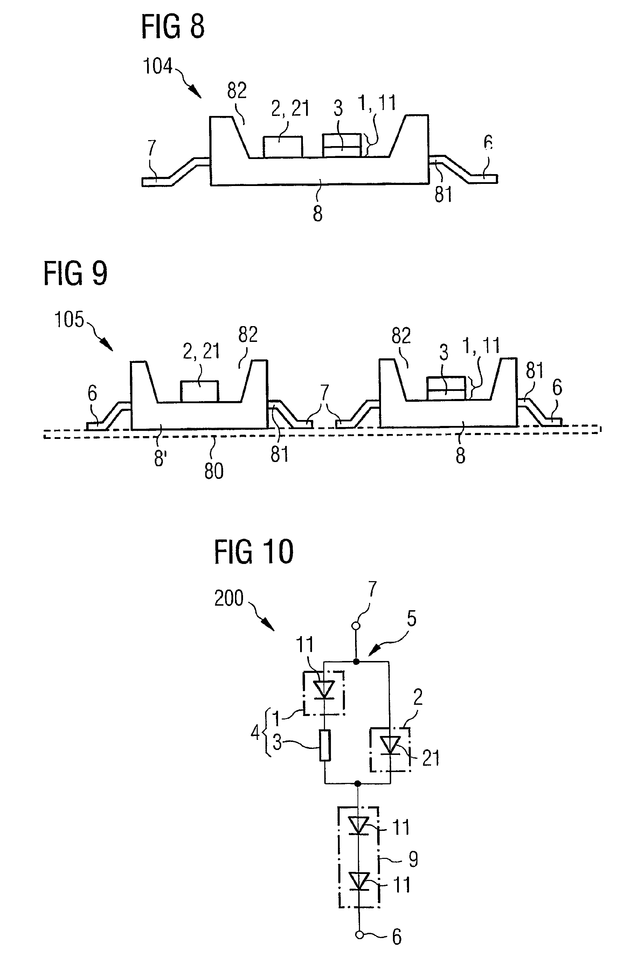

In Figur 8 ist eine weitere optoelektronische Vorrichtung 104 gemäß einem weiteren Ausführungsbeispiel gezeigt, bei der die zumindest eine erste LED 11 der ersten Halbleiterlichtquelle 1 als Dünnfilm-Halbleiter-Chip gemäß der Beschreibung im allgemeinen Teil ausgeführt ist. Als Trägersubstrat weist die erste LED 11 anstelle der üblicherweise verwendeten hochleitfähigen Dünnfilmträger, etwa aus Ge, hochdotiertem Si oder GaAs, das Widerstandselement 3 auf. Das Widerstandselement 3 ist somit in die erste Halbleiterlichtquelle 1 integriert und weist eine ideale weil intrinsische thermische Kopplung des Widerstandselements 3 an die erste Halbleiterlichtquelle 1 auf. Aufgrund der integrierten Bauweise können Selbsterwärmungseffekte des Widerstandselements 3 dabei vernachlässigt werden. Weiterhin muss kein zusätzliches diskretes Bauelement als Widerstandselement 3 verwendet werden, was auch die Produktionskosten senken kann. Insbesondere kann das als Trägersubstrat ausgeführte Widerstandselement 3 geeignet dotiertes Silizium aufweisen, das anstelle der üblicherweise für Dünnfilmträger erwünschten möglichst hohen Leitfähigkeit die hier gewünschte Temperaturabhängigkeit des elektrischen Widerstands aufweist. Alternativ dazu können aber auch Platin als PTC-Material oder gegebenenfalls eines der im allgemeinen Teil genannten NTC-Materialien als Trägersubstrat dienen.

In Figur 9 ist eine optoelektronische Vorrichtung 105 gemäß einem weiteren Ausführungsbeispiel gezeigt, die im Vergleich zu den vorherigen Ausführungsbeispielen ein erstes Gehäuse 8 mit dem Widerstandselement 3 und der ersten Halbleiterlichtquelle 1 und ein zweites Gehäuse 8' mit der zweiten Halbleiterlichtquelle 2 aufweist. Das erste und zweite Gehäuse 8 und 8' können dabei Merkmale wie im zusammenhang mit den vorherigen Ausführungsbeispielen und im allgemeinen Teil ausgeführt aufweisen. Die Gehäuse 8 und 8' sind auf der gestrichelt angedeuteten Leiterplatte 80 angeordnet und über diese thermisch aneinander gekoppelt. Durch die als Wärmesenke fungierende Leiterplatte 80 können die erste und zweite Halbleiterlichtquelle 1, 2 sowie das Widerstandselement 3 die gleiche oder zumindest eine ähnliche Temperatur aufweisen. Weiterhin können die Gehäuse 8 und 8' beispielsweise auch durch einen zusätzlichen Wärmeleiter thermisch aneinander gekoppelt sein. Durch die gezeigte Mehrgehäuseausführung der optoelektronischen Vorrichtung 105 kann eine hohe Flexibilität hinsichtlich der Kombination und räumlichen Anordnung von ersten und zweiten Halbleiterlichtquellen 1, 2 ermöglicht werden.

Bei allen gezeigten baulichen Varianten der optoelektronischen Vorrichtungen ist beispielsweise auch eine Einteilung der ersten und zweiten LEDs 11, 21 hinsichtlich ihrer individuellen Farborte und Intensitäten in so genannten "bins" möglich. Die derart klassifizierten LEDs können dann gezielt mit geeignet gewählten Widerstandselementen 3 kombiniert werden, um Poduktionsserien mit optoelektronischen Vorrichtungen mit einem hinsichtlich Farbort, Intensität und Temperaturabhängigkeit möglichst einheitlichen Mischlicht zu erhalten.

In den folgenden Figuren sind optoelektronische Vorrichtungen gemäß weiterer Ausführungsbeispiele gezeigt, die Modifikationen und Variationen der optoelektronischen Vorrichtung 100 darstellen. Die Beschreibung der folgenden Ausführungsbeispiele beschränkt sich daher hauptsächlich auf die Unterschiede und Weiterbildungen im Vergleich zur vorangegangenen Beschreibung.

In Figur 10 ist eine optoelektronische Vorrichtung 200 gemäß einem weiteren Ausführungsbeispiel gezeigt, die eine dritte Halbleiterlichtquelle 9 aufweist, die in Serie mit der Parallelschaltung 5 gemäß Figur 4 verschaltet ist. Die dritte Halbleiterlichtquelle 9 weist im gezeigten Ausführungsbeispiel eine Mehrzahl von weiteren ersten LEDs 11 auf, von denen rein exemplarisch zwei gezeigt sind. Durch die dritte Halbleiterlichtquelle 9 kann der Farbort des Mischlichts der optoelektronischen Vorrichtung 200 auf einen gewünschten Wert bei einer vorgewählten Umgebungs- und Betriebstemperatur eingestellt werden. Durch die Serienverschaltung der Parallelschaltung 5 mit der dritten Halbleiterlichtquelle 9 ist der Stromfluss durch die dritte Halbleiterlichtquelle 9 etwa bei Anschluss einer Konstantstromquelle an die elektrischen Anschlüsse 6 und 7 unbeeinflusst von der Regelung durch das Widerstandselement 3 in der Parallelschaltung 5. Somit kann bei der optoelektronischen Vorrichtung 200 eine gezielte temperaturabhängige Kompensation der Temperaturabhängigkeiten der ersten und zweiten Halbleiterlichtquellen 1, 2 möglich sein, während die dritte Halbleiterlichtquelle 9 "freilaufend" betrieben wird.

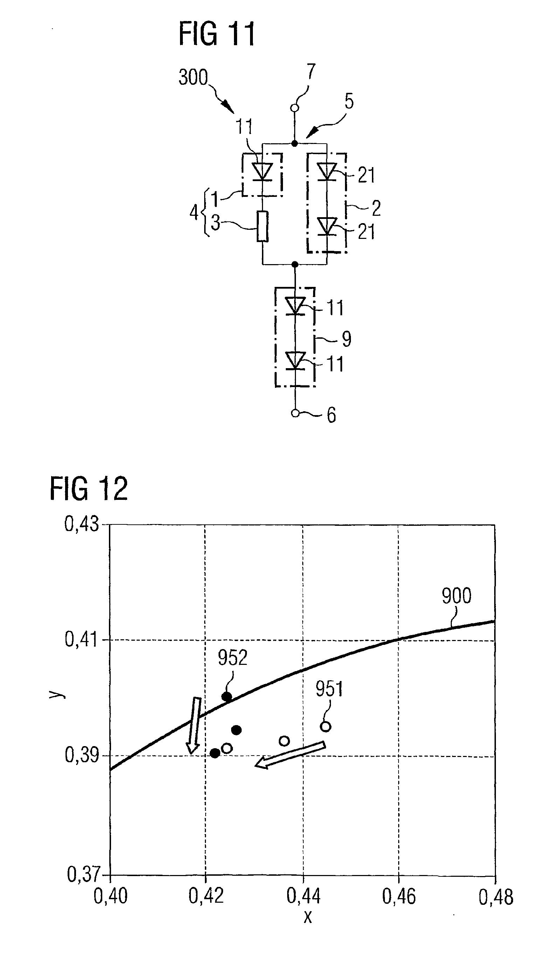

In Figur 11 ist eine optoelektronische Vorrichtung 300 gezeigt, die im Vergleich zum vorherigen Ausführungsbeispiel eine Mehrzahl von zweiten LEDs 21 in der zweiten Halbleiterlichtquelle 2 aufweist, von denen rein beispielhaft zwei gezeigt sind. Dadurch kann für einen gewünschten Farbeindruck des Mischlichts der optoelektronischen Vorrichtung 300 der erforderliche Betriebsstrom für die zweiten LEDs 21 verringert werden, so dass sich auch Selbsterwärmungseffekte in den zweiten LEDs 21 im Vergleich zum vorherigen Ausführungsbeispiel weniger stark ausprägen.

Das Widerstandselement 3 ist im gezeigten Ausführungsbeispiel aus dotiertem Silizium, das aufgrund seiner mit höheren Temperaturen sinkenden Ladungsträgermobilität die erforderliche PTC-Eigenschaft aufweist, die durch einen von der Umgebungstemperatur T abhängigen Widerstand R(T) mit der Charakteristik

$$R(T) = R_0 \cdot (1 + \alpha \cdot (T - T_0) + \beta \cdot (T - T_0)^2)$$

mit den Konstanten $\alpha = 7{,}88 \cdot 10^{-3}$/K, $\beta = 1{,}937 \cdot 10^{-3}$/K$^2$ und der Raumtemperatur $T_0 = 25°$C darstellen lässt, wobei $R_0$ ein durch die Dotierung einstellbarer Widerstandswert bei der Raumtemperatur $T_0$ ist. Zwischen 0°C und 100°C variiert der Widerstand R(T) etwa um einen Faktor 2 mit einem nahezu linearen Verlauf. Die Dotierung des Siliziums ist so gewählt, dass sich bei Raumtemperatur, also 25°C, ein elektrischer Widerstand von etwa 3 bis 5 Ohm ergibt, der insbesondere noch hinsichtlich der gewünschten Farbtemperatur des Mischlichts der optoelektronischen Vorrichtung und der Kennlinien der ersten und zweiten LEDs 11, 21 angepasst werden kann.

Um das Kompensations- und Regelungsverhalten des Widerstandselements 3 hinsichtlich der Temperaturabhängigkeit des Farborts des von der optoelektronischen Vorrichtung 300 abgestrahlten Mischlichts zu demonstrieren, wurden Simulationen durchgeführt, deren Ergebnisse in den folgenden Figuren 12 bis 14 in Ausschnitten der CIE-Normfarbtafel gezeigt sind. Es wurden die Farbortverschiebungen in einem Umgebungstemperaturbereich von 0°C bis 50°C untersucht.

Für alle Simulationen wurde ein Widerstandselement 3 aus Silizium mit dem oben beschriebenen Temperaturabhängigkeit des elektrischen Widerstands R(T) angenommen. Als Modell für die temperaturabhängige Strom-Spannungs-Kennlinie mit dem Strom I in Ampere, der Spannung U in Volt, der Umgebungstemperatur T in Grad Celsius und den Widerständen $R_{11}$ und $R_{21}$ in Ohm wurde für die erste LED 11

$$U_{11} = R_{11} \cdot I + 2{,}902 - (T - 25) \cdot 0{,}004$$

und für die zweite LED 21

$$U_{21} = 2 \cdot (-0{,}07 \cdot I^2 + R_{21} \cdot I + 1{,}85) - (T - 25) \cdot 0{,}0025$$

angenommen. Weiterhin wurden die oben beschriebenen Temperaturabhängigkeiten des ersten und zweiten Wellenlängenbereichs sowie der ersten und zweiten Intensität sowie deren Abhängigkeit vom angelegten Betriebstrom I berücksichtigt.

In Figur 12 wurde $R_0 = 4$ Ohm für das Widerstandselement 3 und $R_{11} = 0{,}879$ Ohm und $R_{21} = 1{,}76$ Ohm für die ersten beziehungsweise zweiten LEDs 11, 21 angenommen. Die Punkte 951 (ungefüllte Kreise) stellen die Farbortverschiebung anhand dreier Punkte für den Temperaturbereich zwischen 0°C und 50°C entlang der durch den Pfeil gekennzeichneten Richtung für eine Vergleichsvorrichtung dar, die im Gegensatz zur optoelektronischen Vorrichtung 300 kein Widerstandselement 3 aufweist, wobei aber dieselben Parameterwerte für die ersten und zweiten LEDs 11, 21 angenommen wurden. Die Farbortverschiebung 951 entspricht bis auf den geringeren betrachteten Temperaturbereich der in den Figuren 1A und 2 gezeigten Farbortänderung der dort gezeigten Farborte 903. Die Punkte 952 (ausgefüllte Punkte) hingegen entsprechen entlang des gezeigten Pfeils der Farbortverschiebung des von der optoelektronischen Vorrichtung 300 abgestrahlten Mischlichts. Die regulierende und kompensierende Wirkung des Widerstandselements 3 auf den Farbort des abgestrahlten Mischlichts ist leicht erkennbar. Insbesondere wird mit Verweis auf die Figuren 1B und 2 für die optoelektronische Vorrichtung 300 eine Farbortverschiebung entlang der Hauptachse einer MacAdams-Ellipse ermöglicht.

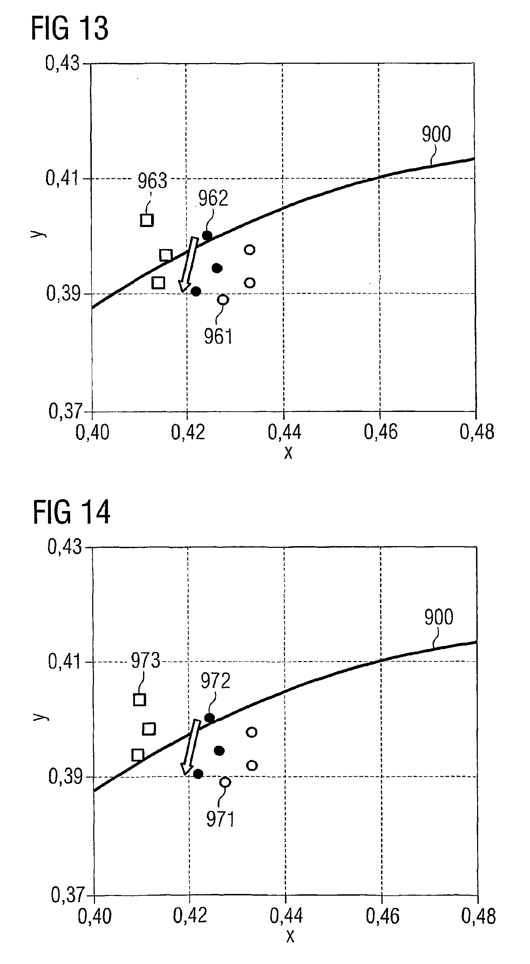

In Figur 13 wurde der Widerstand $R_0$ des Widerstandselements 3 variiert und beträgt für die Punkte 961 (ungefüllte Kreise) 3 Ohm, für die Punkte 962 (gefüllte Punkte) entsprechend der Punkte 952 der Figur 12 4 Ohm und für die Punkte 963 (ungefüllte Vierecke) 5 Ohm. Hierbei ist zu erkennen, dass der Farbortbereich beziehungsweise der mittlere Weißpunkt, auf den stabilisiert wird, durch Wahl des Widerstands $R_0$ des Widerstandelements 3 variiert werden kann, die Regelungs- und Kompensationseigenschaften davon aber unberührt bleiben.

In Figur 14 wurde wiederum $R_0$ = 4 Ohm angenommen, wohingegen die Widerstände $R_{11}$ und $R_{21}$ der ersten und zweiten LEDs 11, 21 variiert wurden. Die Punkte 972 (ausgefüllte Punkte) entsprechen wieder den Punkten 952 der Figur 12, also $R_{11}$ = 0,879 Ohm und $R_{21}$ = 1,76 Ohm. Für die Punkte 971 (ungefüllte Kreise) wurde für die zweiten LEDs 21 ein um 1 Ohm erhöhter Widerstand, also $R_{21}$ = 2,76 Ohm, angenommen, während für die Punkte 973 (ungefüllte Vierecke) für die ersten LEDs 11 ein um 1 Ohm erhöhter Widerstand, also $R_{11}$ = 1,879 Ohm, angenommen wurde. Bei einem Betriebstrom von 350 Milliampere hat sich dadurch im Fall der Punkte 971 die Betriebsspannung der zweiten LEDs bei Raumtemperatur von 2,1 Volt auf 2,28 Volt erhöht, im Fall der Punkte 973 hat sich hingegen die Betriebspannung der ersten LEDs bei Raumtemperatur von 3,21 Volt auf 3,56 Volt erhöht. Zu erkennen ist aus Figur 14 wiederum, dass durch Anpassung der Widerstände der LEDs zwar der Farbortbereich beziehungsweise der mittleren Weißpunkt es Mischlichts, auf den stabilisiert wird, variiert werden kann, die Regelungs- und Kompensationseigenschaften durch das Widerstandselement 3 davon aber unberührt bleiben.

Die optoelektronische Vorrichtung 300 kann somit beispielsweise zusätzlich auch ein elektrisches Bauelement wie etwa einen regelbaren Widerstand, eine Festwiderstand oder ein aktives Element wie etwa einen Transistor aufweisen, durch die der mittlere Farbort des Mischlichts fest eingestellt werden kann, ohne dass die Regelungs- und Kompensationseigenschaften des Widerstandelements 3 in der Parallelschaltung 5 beeinflusst werden.

Bei der optoelektronischen Vorrichtung 300 wie auch bei den optoelektronischen Vorrichtungen der anderen Ausführungsbeispiele kann weiterhin der Farbort des durch eine Überlagerung des Lichts der ersten und zweiten Halbleiterlichtquelle 1, 2 hervorgerufenen Leuchteindrucks vorab ohne das Widerstandselement 3 charakterisiert werden. Nachfolgen kann ein hinsichtlich seinem temperaturabhängigen elektrischen Widerstand geeignetes Widerstandselement 3 gezielt in Bezug auf das erwünschte Mischlicht hinzugefügt werden.

In den für Mischlicht mit einem Weißpunkt bei einer Farbtemperatur von etwa 3000 Kelvin gezeigten Simulationen ergibt sich eine Effizienzeinbuße durch Verwendung des Widerstandelements 3 unter allen sinnvollen Betriebsbedingungen von weniger als etwa 6% und in der Regel sogar von weniger als 4% im Vergleich zu einer Vorrichtung ohne Widerstrandselement 3. Obwohl durch das Widerstandelement 3 eine ohmsche Verlustquelle eingeführt wird, wurde für die hier beschriebenen optoelektronischen Vorrichtungen somit überraschenderweise herausgefunden, dass die Verluste akzeptabel gering gehalten werden können und eine erhebliche Farbortstabilisierung bei einfachem technischem Aufwand möglich ist.

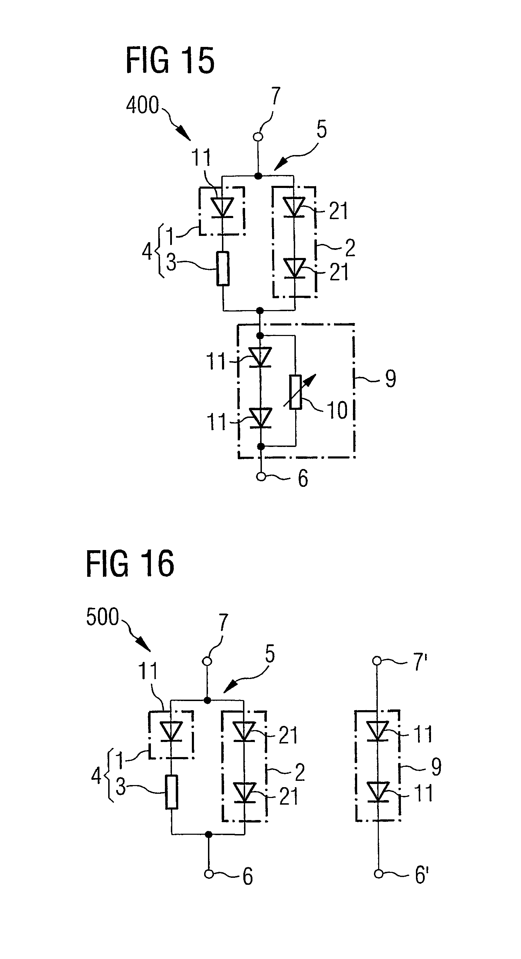

In den Figuren 15 bis 17 sind weitere Ausführungsbeispiele gezeigt, die weitere Modifikationen und Ausgestaltungen der vorherigen Ausführungsbeispiele darstellen.

Die optoelektronische Vorrichtung 400 gemäß Figur 15 weist im Vergleich zur optoelektronischen Vorrichtung 300 ein elektronisches Bauelement 10 in der dritten Halbleiterlichtquelle 9 auf, das geeignet ist, das Mischlicht bei einer vorgewählten Umgebungs- und Betriebstemperatur der optoelektronischen Vorrichtung 400 einzustellen. Das elektronische Bauelement 10 weist im gezeigten Ausführungsbeispiel einen einstellbaren Widerstand auf, der parallel zu den ersten LEDs 11 der dritten Halbleiterlichtquelle 9 verschaltet ist. Alternativ oder zusätzlich kann das elektronische Bauelement 10 auch einen oder mehrere weitere Festwiderstände, einstellbare Widerstände oder Transistoren wie etwa MOSFETs aufweisen, die geeignet sind, den der ersten, zweiten und/oder gegebenenfalls dritten Halbleiterlichtquelle aufgeprägten Strom für eine vorgewählte Betriebs- und Umgebungstemperatur einzustellen und so einen Abgleich der Anteile mit dem ersten und zweiten Wellenlängenbereich am Mischlicht einzustellen.

In Figur 16 ist eine weitere optoelektronische Vorrichtung 500 gezeigt, bei der die dritte Halbleiterlichtquelle 9 mit den ersten LEDs 11 unabhängig von der Parallelschaltung 5 über elektrische Anschlüsse 6' und 7' verschaltet ist. Dadurch ist ein Farbortabgleich des Mischlichts mit unterschiedlichen Schaltungssträngen möglich.

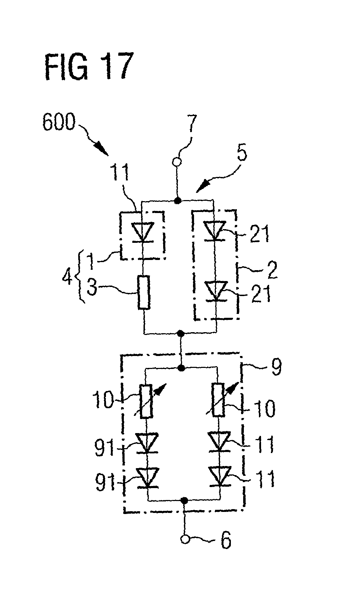

In Figur 17 ist eine optoelektronische Vorrichtung 600 gezeigt, die eine dritte Halbleiterlichtquelle 9 mit einer Parallelschaltung mit ersten LEDs 11 und dritten LEDs 91 aufweist. Die dritten LEDs 91 erzeugen Licht mit einem dritten Wellenlängenbereich, der verschieden vom ersten und zweiten Wellenlängenbereich ist. Beispielsweise weisen die dritten LEDs 91 im Vergleich zu den ersten LEDs 11 dieselben Epitaxieschichtenfolgen in Kombination mit weniger Wellenlängenkonversionsstoff auf, so dass der dritte Wellenlängenbereich im Vergleich zum ersten Wellenlängenbereich einen weißen Farbeindruck mit einer höheren Farbtemperatur beziehungsweise einem höheren Blauanteil erweckt.

Zu den ersten und dritten LEDs 11, 91 ist jeweils ein elektrisches Bauelement 10 zu Einstellung des Stroms in den beiden Zweigen der Parallelschaltung der dritten Halbleiterlichtquelle 9 angeordnet. Dadurch kann ein erhöhter Freiheitsgrad hinsichtlich der Einstellung eines mittleren Farborts des von der optoelektronischen Vorrichtung 600 abgestrahlten Mischlichts erreicht werden. Im gezeigten Ausführungsbeispiel mit den vorab beschriebenen ersten, zweiten und dritten LEDs 11, 21, 91 ermöglicht somit die Parallelschaltung 5 eine Farbortstabilisierung im Hinblick auf Temperaturänderungen, während die dritte Halbleiterlichtquelle 9 eine fest wählbare Feineinstellung des mittleren Weißpunkts des Mischlichts ermöglicht. Im gezeigten Ausführungsbeispiel mit den oben genannten elektrischen Spezifikationen der LEDs und des Widerstandselements 3 ergibt sich für die optoelektronische Vorrichtung 600 bei einem Gesamtstrom von etwa 500 Milliampere eine Gesamtspannung von etwa 11 Volt, wobei für eine beispielhafte Einstellung des Mischlichts bei Raumtemperatur an der ersten LED 11 in der Parallelschaltung etwa 3,15 Volt anliegen, an den zweiten LEDs etwa 4,2 Volt, an den elektrischen Bauelementen der dritten Halbleiterlichtquelle 9 etwa 0,5 Volt und an den ersten und dritten LEDs der dritten Halbleiterlichtquelle 9 etwa 3,15 Volt.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

**Patentansprüche**

1. Optoelektronische Vorrichtung zur Abstrahlung von Mischlicht mit Licht in einem ersten und einem zweiten Wellenlängenbereich, umfassend:

   - eine erste Halbleiterlichtquelle (1) mit einer ersten lichtemittierenden Diode (11), die im Betrieb Licht im ersten Wellenlängenbereich mit einer ersten Intensität abstrahlt,
   - eine zweite Halbleiterlichtquelle (2) mit einer zweiten lichtemittierenden Diode (21), die im Betrieb Licht im zweiten Wellenlängenbereich mit einer zweiten Intensität abstrahlt, wobei der erste und zweite Wellenlängenbereich voneinander verschieden sind, und
   - ein Widerstandselement (3) mit einem temperaturabhängigen elektrischen Widerstand,

   wobei

   - der erste Wellenlängenbereich und/oder die erste Intensität des von der ersten Halbleiterlichtquelle (1) abgestrahlten Lichts eine erste Temperaturabhängigkeit aufweist,
   - der zweite Wellenlängenbereich und/oder die zweite Intensität des von der zweiten Halbleiterlichtquelle (2) abgestrahlten Lichts eine zweite Temperaturabhängigkeit aufweist, die verschieden von der ersten Temperaturabhängigkeit ist,
   - das Widerstandselement (3) und die erste Halbleiterlichtquelle (1) eine Serienschaltung (4) bilden und
   - die Serienschaltung (4) und die zweite Halbleiterlichtquelle (2) eine Parallelschaltung (5) bilden,

   **dadurch gekennzeichnet, dass**

   - zumindest eine der ersten und zweiten Halbleiterlichtquelle (1, 2) eine Licht emittierende Diode (11, 21) mit einem Wellenlängenkonversionsstoff aufweist und einen weißen Leuchteindruck erweckt, während die andere der ersten und zweiten Halbleiterlichtquelle (1, 2) einen farbigen Leuchteindruck erweckt, und
   - das Mischlicht durch das mit der ersten und zweiten Halbleiterlichtquelle (1, 2) verschaltete Widerstandselement (3) hinsichtlich seines Farborts stabilisiert werden kann.

2. Vorrichtung nach Anspruch 1, wobei

   - die erste Temperaturabhängigkeit kleiner als die zweite Temperaturabhängigkeit ist und
   - das Widerstandselement (3) ein Widerstandselement mit einem positiven Temperaturkoeffizienten ist.

3. Vorrichtung nach Anspruch 2, wobei

   - das Widerstandselement (3) Platin oder Silizium aufweist.

4. Vorrichtung nach Anspruch 1, wobei

   - die erste Temperaturabhängigkeit größer als die zweite Temperaturabhängigkeit ist und
   - das Widerstandselement (3) ein Widerstandselement mit einem negativen Temperaturkoeffizienten ist.

5. Vorrichtung nach einem der vorherigen Ansprüche, wobei

   - der elektrische Widerstand des Widerstandselements (3) in einem Temperaturbereich von größer oder gleich -40°C und kleiner oder gleich 125°C kontinuierlich variiert.

**6.** Vorrichtung nach einem der vorherigen Ansprüche, weiterhin umfassend

- zumindest ein elektronisches Bauelement (10) in der Parallelschaltung (4) zur Einstellung des Mischlichts bei einer vorbestimmten Temperatur,

wobei

- das zumindest eine elektronische Bauelement (10) ausgewählt ist aus einem Festwiderstand, einem einstellbaren Widerstand und einem Transistor.

**7.** Vorrichtung nach einem der vorherigen Ansprüche, wobei

- die Parallelschaltung (4) mit zumindest einer dritten Halbleiterlichtquelle (9) in Serie geschaltet ist und
- die dritte Halbleiterlichtquelle (9) zumindest eine weitere erste lichtemittierende Diode (11) aufweist.

**8.** Vorrichtung nach Anspruch 7, wobei

- die dritte Halbleiterlichtquelle (9) zumindest ein elektronisches Bauelement (10) aufweist zur Einstellung eines relativen Intensitätsverhältnisses der dritten Halbleiterlichtquelle (9) und der Parallelschaltung (4) bei einer vorbestimmten Temperatur.

**9.** Vorrichtung nach Anspruch 8, wobei

- die dritte Halbleiterlichtquelle (9) zumindest eine dritte lichtemittierende Diode (91) aufweist, die im Betrieb Licht in einem dritten Wellenlängenbereich abstrahlt, der verschieden vom ersten Wellenlängenbereich ist und
- mittels des zumindest einen elektronischen Bauelements (10) ein relatives Intensitätsverhältnis der ersten lichtemittierenden Diode (11) und der dritten lichtemittierenden Diode (91) in der dritten Halbleiterlichtquelle (9) bei einer vorbestimmten Temperatur einstellbar ist.

**10.** Vorrichtung nach einem der Ansprüche 1 bis 9, wobei

- das Widerstandselement (3) zumindest mit der ersten Halbleiterlichtquelle (1) über einen Wärmeleiter (13) in thermischem Kontakt steht.

**11.** Vorrichtung nach einem der Ansprüche 1 bis 9, wobei

- die erste Halbleiterlichtquelle (1) direkt auf dem Widerstandselement (3) aufgebracht ist.

**12.** Vorrichtung nach einem der Ansprüche 1 bis 9, wobei

- das Widerstandselement (3) als Trägersubstrat für die erste lichtemittierende Diode (11) ausgebildet ist.

**13.** Vorrichtung nach einem der Ansprüche 1 bis 12, wobei

- die optoelektronische Vorrichtung weiterhin ein Gehäuse (8) aufweist, in dem die erste und zweite Halbleiterlichtquelle (1, 2) und das Widerstandselement (3) angeordnet sind.

**14.** Vorrichtung nach einem der Ansprüche 1 bis 12, weiterhin umfassend

- ein erstes Gehäuse (8) mit der ersten Halbleiterlichtquelle (1) und dem Widerstandselement (3) und ein zweite Gehäuse (8') mit der zweiten Halbleiterlichtquelle (2) aufweist,

wobei

- das erste und zweite Gehäuse (8, 8') in thermischem Kontakt stehen.

**15.** Vorrichtung nach einem der vorherigen Ansprüche, wobei

- das Mischlicht in einem Temperaturbereich von größer oder gleich 0°C und kleiner oder gleich 100°C eine temperaturabhängige Farbortverschiebung um einen mittleren Farbort aufweist, die entlang einer Hauptachse einer MacAdams-Ellipse um den mittleren Farbort herum verläuft.

**Claims**

1. Optoelectronic device for emitting mixed light comprising light in a first and a second wavelength range, comprising:

   - a first semiconductor light source (1) having a first light-emitting diode (11), which during operation emits light in the first wavelength range with a first intensity,
   - a second semiconductor light source (2) having a second light-emitting diode (21), which during operation emits light in the second wavelength range with a second intensity, wherein the first and second wavelength ranges are different from one another, and
   - a resistance element (3) having a temperature-dependent electrical resistance,

   wherein

   - the first wavelength range and/or the first intensity of the light emitted by the first semiconductor light source (1) have/has a first temperature dependence,
   - the second wavelength range and/or the second intensity of the light emitted by the second semiconductor light source (2) have/has a second temperature dependence, which is different from the first temperature dependence,
   - the resistance element (3) and the first semiconductor light source (1) form a series circuit (4), and
   - the series circuit (4) and the second semiconductor light source (2) form a parallel circuit (5),

   **characterized in that**

   - at least one of the first and second semiconductor light sources (1, 2) has a light-emitting diode (11, 21) comprising a wavelength conversion substance and brings about a white luminous impression, while the other of the first and second semiconductor light sources (1, 2) brings about a coloured luminous impression, and
   - the mixed light can be stabilized with regard to its colour locus by the resistance element (3) interconnected with the first and second semiconductor light sources (1, 2).

2. Device according to Claim 1, wherein

   - the first temperature dependence is smaller than the second temperature dependence, and
   - the resistance element (3) is a resistance element having a positive temperature coefficient.

3. Device according to Claim 2, wherein

   - the resistance element (3) comprises platinum or silicon.

4. Device according to Claim 1, wherein

   - the first temperature dependence is greater than the second temperature dependence, and
   - the resistance element (3) is a resistance element having a negative temperature coefficient.

5. Device according to any of the preceding claims, wherein

   - the electrical resistance of the resistance element (3) varies continuously in a temperature range of greater than or equal to -40°C and less than or equal to 125°C.

6. Device according to any of the preceding claims, furthermore comprising

   - at least one electronic component (10) in the parallel circuit (4) for setting the mixed light at a predetermined temperature,

wherein

- the at least one electronic component (10) is selected from a fixed resistor, a variable resistor and a transistor.

7. Device according to any of the preceding claims, wherein

- the parallel circuit (4) is connected in series with at least one third semiconductor light source (9), and
- the third semiconductor light source (9) has at least one further first light-emitting diode (11).

8. Device according to Claim 7, wherein

- the third semiconductor light source (9) has at least one electronic component (10) for setting a relative intensity ratio of the third semiconductor light source (9) and the parallel circuit (4) at a predetermined temperature.

9. Device according to Claim 8, wherein

- the third semiconductor light source (9) has at least one third light-emitting diode (91), which during operation emits light in a third wavelength range, which is different from the first wavelength range, and
- by means of the at least one electronic component (10) it is possible to set a relative intensity ratio of the first light-emitting diode (11) and of the third light-emitting diode (91) in the third semiconductor light source (9) at a predetermined temperature.

10. Device according to any of Claims 1 to 9, wherein

- the resistance element (3) is in thermal contact at least with the first semiconductor light source (1) via a heat conductor (13).

11. Device according to any of Claims 1 to 9, wherein

- the first semiconductor light source (1) is applied directly on the resistance element (3).

12. Device according to any of Claims 1 to 9, wherein

- the resistance element (3) is embodied as a carrier substrate for the first light-emitting diode (11).

13. Device according to any of Claims 1 to 12, wherein

- the optoelectronic device furthermore has a housing (8), in which the first and second semiconductor light sources (1, 2) and the resistance element (3) are arranged.

14. Device according to any of Claims 1 to 12, furthermore comprising

- a first housing (8) with the first semiconductor light source (1) and the resistance element (3) and a second housing (8') with the second semiconductor light source (2),

wherein

- the first and second housings (8, 8') are in thermal contact.

15. Device according to any of the preceding claims, wherein

- the mixed light in a temperature range of greater than or equal to 0°C and less than or equal to 100°C has a temperature-dependent colour locus shift by an average colour locus, which shift runs along a major axis of a MacAdams ellipse around the average colour locus.

**Revendications**

1. Dispositif optoélectronique destiné à émettre un mélange de lumière qui présente de la lumière dans une première plage de longueurs d'onde et de la lumière dans une deuxième plage de longueurs d'onde, le dispositif comprenant :

   une première source semi-conductrice de lumière (1) dotée d'une première diode (11) émettant de la lumière qui, en fonctionnement, émet de la lumière à une première intensité dans la première plage de longueurs d'onde, une deuxième source semi-conductrice de lumière (2) qui présente une deuxième diode (21) émettant de la lumière qui, en fonctionnement, émet de la lumière à une deuxième intensité dans la deuxième plage de longueurs d'onde, la première et la deuxième plage de longueurs d'onde étant différentes l'une de l'autre et un élément de résistance (3) dont la résistance électrique dépend de la température,
   la première plage de longueurs d'onde et/ou la première intensité de la lumière émise par la première source semi-conductrice de lumière (1) présentant une première dépendance vis-à-vis de la température,
   la deuxième plage de longueurs d'onde et/ou la deuxième intensité de la lumière émise par la deuxième source semi-conductrice de lumière (2) présentant une deuxième dépendance vis-à-vis de la température, différente de la première dépendance vis-à-vis de la température,
   l'élément de résistance (3) et la première source semi-conductrice de lumière (1) formant un circuit série (4) et le circuit-série (4) et la deuxième source semi-conductrice de lumière (2) formant un circuit parallèle (5),
   **caractérisé en ce que**
   au moins l'une parmi la première et la deuxième source semi-conductrice de lumière (1, 2) présente une diode (11, 21) émettant de la lumière et présentant une première substance de conversion de longueur d'onde et crée une impression de lumière blanche, tandis que l'autre parmi la première et la deuxième source semi-conductrice de lumière (1, 2) émet une impression de lumière colorée et
   **en ce que** la localisation chromatique du mélange de lumière peut être stabilisée par l'élément de résistance (3) raccordé à la première et à la deuxième source semi-conductrice de lumière (1, 2).

2. Dispositif selon la revendication 1, dans lequel la première dépendance vis-à-vis de la température est plus faible que la deuxième dépendance vis-à-vis de la température et en ce que l'élément de résistance (3) est un élément de résistance dont le coefficient de température est positif.

3. Dispositif selon la revendication 2, dans lequel l'élément de résistance (3) présente du platine ou du silicium.

4. Dispositif selon la revendication 1, dans lequel la première dépendance vis-à-vis de la température est supérieure à la deuxième dépendance vis-à-vis de la température et en ce que l'élément de résistance (3) est un élément de résistance à coefficient de température négatif.

5. Dispositif selon l'une des revendications précédentes, dans lequel la résistance électrique de l'élément de résistance (3) varie de manière continue dans la plage des températures supérieures ou égales à -40°C et inférieures ou égales à 125°C.

6. Dispositif selon l'une des revendications précédentes, comprenant en outre au moins un composant électronique (10) prévu dans le circuit parallèle (4) pour ajuster le mélange de lumière à une température prédéterminée, le ou les composants électroniques (10) étant sélectionnés parmi une résistance fixe, une résistance variable et un transistor.

7. Dispositif selon l'une des revendications précédentes, dans lequel le circuit parallèle (4) est raccordé en série à au moins une troisième source semi-conductrice de lumière (9) et la troisième source semi-conductrice de lumière (9) présente au moins une autre diode (11) émettant de la lumière.

8. Dispositif selon la revendication 7, dans lequel la troisième source semi-conductrice de lumière (9) présente au moins un composant électronique (10) destiné à établir un rapport d'intensité relative entre la troisième source semi-conductrice de lumière (9) et le circuit parallèle (4) à une température prédéterminée.

9. Dispositif selon la revendication 8, dans lequel la troisième source semi-conductrice de lumière (9) présente au moins une troisième diode (91) émettant de la lumière qui, en fonctionnement, émet de la lumière dans une troisième plage de longueurs d'onde différente de la première plage de longueurs d'onde, le rapport des intensités relatives de la première diode (11) émettant de la lumière et de la troisième diode (91) émettant de la lumière de la troisième source semi-conductrice de lumière (9) pouvant être ajusté à une température prédéterminée au moyen du ou des composants électroniques (10).

10. Dispositif selon l'une des revendications 1 à 9, dans lequel l'élément de résistance (3) est en contact thermique par l'intermédiaire d'un conducteur de chaleur (13) avec au moins la première source semi-conductrice de lumière (1).

11. Dispositif selon l'une des revendications 1 à 9, dans lequel la première source semi-conductrice de lumière (1) est appliquée directement sur l'élément de résistance (3).

12. Dispositif selon l'une des revendications 1 à 9, dans lequel l'élément de résistance (3) est configuré comme substrat porteur de la première diode (11) émettant de la lumière.

13. Dispositif selon l'une des revendications 1 à 12, dans lequel le dispositif optoélectronique présente en outre un boîtier (8) dans lequel sont disposés la première et la deuxième source semi-conductrice de lumière (1, 2) ainsi que l'élément de résistance (3).

14. Dispositif selon l'une des revendications 1 à 12, comprenant en outre un premier boîtier (8) qui présente la première source semi-conductrice de lumière (1) et l'élément de résistance (3) et un deuxième boîtier (8') qui présente la deuxième source semi-conductrice de lumière (2), le premier et le deuxième boîtier (8, 8') étant en contact thermique mutuel.

15. Dispositif selon l'une des revendications précédentes, dans lequel dans la plage des températures supérieures ou égales à 0°C et inférieures ou égales à 100°C, le mélange de lumière présente en fonction de la lumière un décalage de sa localisation chromatique par rapport à une localisation chromatique moyenne, le décalage s'étendant autour de la localisation chromatique moyenne le long d'un axe principal d'une ellipse de MacAdams.

EP 2 351 461 B1

FIG 1A

20

FIG 1B

FIG 2

FIG 3A

# FIG 3B

# FIG 4

## FIG 5

101

2, 21   1, 11   3   82

7   8   81   6

## FIG 6

102

2, 21   1, 11   3   82

7   8   13   81   6

## FIG 7

103

2, 21   1, 11   82

7   8   3   81   6

EP 2 351 461 B1

FIG 8

FIG 9

FIG 10

25

FIG 11

FIG 12

## FIG 13

## FIG 14

# FIG 15

# FIG 16

FIG 17

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008057347
- US 2007171159 A1
- US 2008111505 A1
- JP 2002008904 A
- EP 1950490 A2
- US 2005185113 A1
- WO 2007060570 A1

**In der Beschreibung aufgeführte Nicht-Patentliteratur**

- Data Sheet: Circuit Protection Thermistors NT05 25311. Amatherm Inc, 12. August 2002